# EUROPEAN PATENT APPLICATION

(11) **EP 3 358 603 A1**
(43) Date of publication of application: **08.08.2018**
(21) Application number: 15905451.9
(22) Date of filing: 01.10.2015
(51) Int. Cl.: H01L 21/3205, H01L 21/768, H01L 23/522

(54) **SEMICONDUCTOR DEVICE AND METHOD FOR MANUFACTURING SAME**

(71) Applicant: Renesas Electronics Corporation, Tokyo 135-0061 (JP)
(72) Inventor: MATSUMOTO, Masahiro, Hitachinaka-shi Ibaraki 312-8504 (JP); ICHINOSE, Kazuhito, Hitachinaka-shi Ibaraki 312-8504 (JP); YAJIMA, Akira, Hitachinaka-shi Ibaraki 312-8504 (JP)
(74) Representative: Moore, Graeme Patrick
(86) International application number: PCT/JP2015/077970
(87) International publication number: WO 2017/056297

(57) **Abstract**

It is possible to prevent deterioration of a redistribution layer due to exposure of the redistribution layer from an upper insulating film and the resultant reaction with moisture, ions, or the like. As means thereof, in a semiconductor device having a plurality of wiring layers formed in an element formation region and having a redistribution layer connected with a pad electrode which is an uppermost wiring layer, a dummy pattern is arranged in a region closer to a scribe region than the redistribution layer.

## Description

### TECHNICAL FIELD

The present invention relates to a semiconductor device and a method of manufacturing the same and for example, can be used for manufacturing a semiconductor device having a redistribution layer.

### BACKGROUND ART

In recent years, a wiring layer, called a redistribution layer, formed over an uppermost first pad of a layered wiring layer over a semiconductor substrate has been used from demands of speeding up and downsizing of a semiconductor device. The redistribution layer includes a thick Cu (copper) film formed by plating, for example, and has a low wiring resistance, so that the redistribution layer is used for high-speed processing or analog elements. A second pad electrode is formed over an upper surface of the redistribution layer, and the redistribution layer is electrically connected with a printed circuit board or the like via a bonding wire or a solder ball connected to the second pad electrode.

Patent Document 1 (Japanese Patent Application Laid-Open Publication No. 2010-278040), Patent Document 2 (Japanese Patent Application Laid-Open Publication No. 2012-221984), and Patent Document 3 (Japanese Patent Application Laid-Open Publication No. 2009-88002) describe that a redistribution layer is formed over a layered wiring layer.

### RELATED ART DOCUMENTS

### PATENT DOCUMENTS

Patent Document 1: Japanese Patent Application Laid-Open Publication No. 2010-278040
Patent Document 2: Japanese Patent Application Laid-Open Publication No. 2012-221984
Patent Document 3: Japanese Patent Application Laid-Open Publication No. 2009-88002

### SUMMARY OF THE INVENTION

### PROBLEMS TO BE SOLVED BY THE INVENTION

In order to protect the redistribution layer constituting a circuit from moisture or the like, the redistribution layer needs to be covered with an insulating film comprised of polyimide or the like formed over the redistribution layer. However, due to a step between an upper surface of a scribe line and the upper surface of the redistribution layer at an end of a chip, a film thickness of the insulating film formed by coating becomes small at the end of the chip. For this reason, a part of the redistribution layer formed at the end of the chip tends to be exposed from the insulating film, resulting in deterioration of reliability of the semiconductor device. Further, if the redistribution layer is arranged to be separated from the end of the chip in order to avoid the deterioration, it is difficult to miniaturize a semiconductor chip. As a result, a chip area increases, and the number of acquired chips per wafer decreases. That is, the manufacturing cost increases.

Other objects and novel features will become apparent from the description of the present specification and the accompanied drawings.

### MEANS FOR SOLVING THE PROBLEMS

The typical ones of the embodiments disclosed in the present application will be briefly described as follows.

A semiconductor device and a method of manufacturing the same according to one embodiment include a semiconductor substrate having an element formation region and a scribe region surrounding the element formation region. Further, a plurality of wiring layers formed in the element formation region and a pad electrode formed in an uppermost layer of the plurality of wiring layers are provided. Further, a first insulating film formed over the pad electrode and having a first opening and a second insulating film formed over the first insulating film and having a second opening are provided. Further, a redistribution layer formed over the second insulating film and electrically connected with the pad electrode via the first and the second openings is provided. Further, a dummy pattern over the second insulating film and arranged in a region closer to the scribe region than the redistribution layer is provided. Further, a third insulating film having a third opening above the redistribution layer and formed over the redistribution layer and over the dummy pattern is provided.

### EFFECTS OF THE INVENTION

According to one embodiment, reliability of a semiconductor device can be improved. In particular, it is possible to prevent deterioration of a wiring caused by exposure of the redistribution layer from an upper-layer insulating film.

According to another embodiment, it is possible to miniaturize a semiconductor device, and manufacturing cost of the semiconductor device can be suppressed.

### BRIEF DESCRIPTIONS OF THE DRAWINGS

FIG 1 is a plan view of a semiconductor device according to a first embodiment;
FIG 2 is a cross-sectional view of the semiconductor device according to the first embodiment;
FIG 3 is a cross-sectional view of a structure mounted over a substrate of the semiconductor device according to the first embodiment;
FIG 4 is a cross-sectional view of the semiconductor device according to the first embodiment during a manufacturing process;
FIG. 5 is a cross-sectional view of the semiconductor device during the manufacturing process continued from FIG 4;
FIG 6 is a cross-sectional view of the semiconductor device during the manufacturing process continued from FIG. 5;
FIG 7 is a cross-sectional view of the semiconductor device during the manufacturing process continued from FIG 6;
FIG 8 is a cross-sectional view of the semiconductor device during the manufacturing process continued from FIG 7;
FIG 9 is a cross-sectional view of the semiconductor device during the manufacturing process continued from FIG 8;
FIG 10 is a cross-sectional view of the semiconductor device during the manufacturing process continued from FIG 9;
FIG 11 is a cross-sectional view of the semiconductor device during the manufacturing process continued from FIG. 10;
FIG 12 is a plan view of the semiconductor device during the manufacturing process continued from FIG 11;
FIG 13 is a cross-sectional view of the semiconductor device during the manufacturing process continued from FIG. 11;
FIG 14 is a cross-sectional view of the semiconductor device during the manufacturing process continued from FIG 13;
FIG 15 is a cross-sectional view of the semiconductor device during the manufacturing process continued from FIG. 14;
FIG 16 is a cross-sectional view of a semiconductor device according to a first modification example of the first embodiment;
FIG 17 is a plan view of a semiconductor device according to a second modification example of the first embodiment;
FIG 18 is a plan view of a semiconductor device according to a second embodiment;
FIG 19 is a cross-sectional view of a structure mounted on a substrate of the semicondcutor device according to the second embodiment;
FIG 20 is a cross-sectional view of a semiconductor device according to a third embodiment;
FIG 21 is a cross-sectional view of a semiconductor device according to a fourth embodiment;
FIG 22 is a cross-sectional view of the semiconductor device according to the fourth embodiment;
FIG 23 is a cross-sectional view of a semiconductor device according to a comparative example; and
FIG 24 is a cross-sectional view of a semiconductor device according to another comparative example.

### DETAILED DESCRIPTION OF PREFERRED EMBODIMENTS

Hereinafter, embodiments of the present invention will be described in detail with reference to the accompanying drawings. Note that components having the same function are denoted by the same reference characters throughout the drawings for describing the embodiments, and the repetitive description thereof is omitted. In addition, the description of the same or similar portions is not repeated in principle unless particularly required in the following embodiments.

### (First Embodiment)

A semiconductor device of the present embodiment and the following embodiments is a semiconductor device provided with a redistribution layer.

### <Structure of Semiconductor Device>

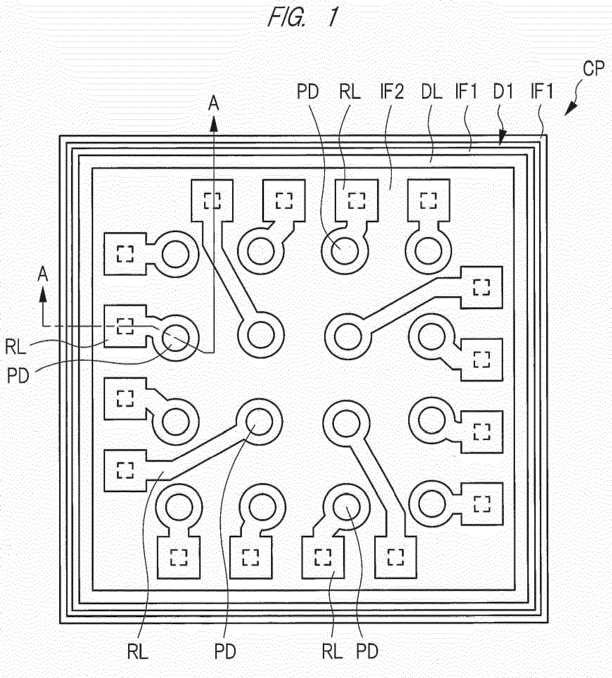

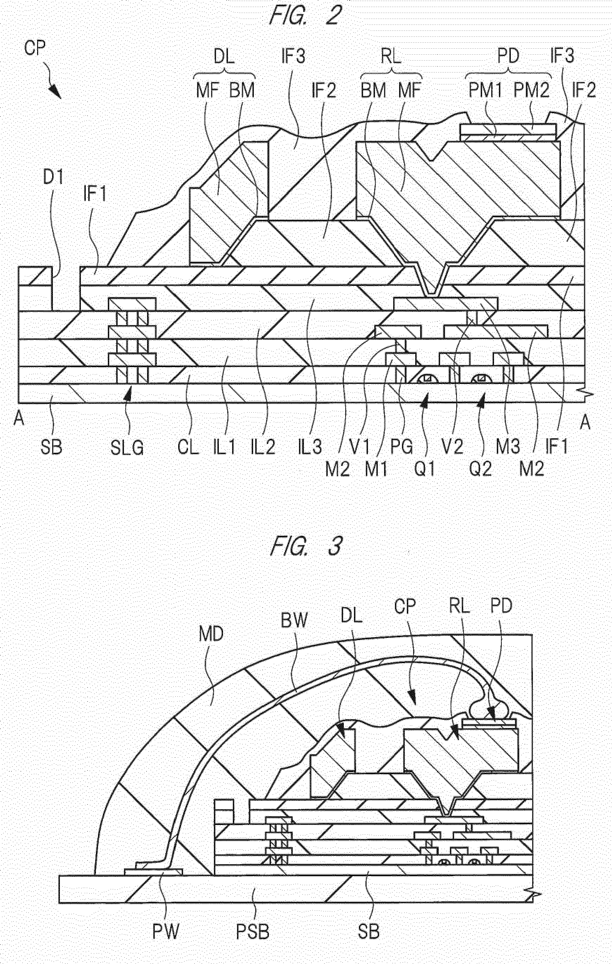

A structure of the present embodiment will be described with reference to FIG 1 to FIG 3. FIG 1 is a plan layout of a semiconductor chip which is a semiconductor device of the present embodiment FIG 2 is a cross-sectional view taken along a line A-A in FIG 1, and is a cross-sectional view illustrating an end of the semiconductor chip which is the semiconductor device of the present embodiment FIG 3 is a cross-sectional view illustrating a structure in which the semiconductor chip which is the semiconductor device of the present embodiment is mounted over a substrate. In FIG 1, illustration of an upper insulating film IF3 (see FIG 2) formed over the redistribution layer is omitted. Note that, in the present application, a printed circuit board (wiring board) or a board on which a chip is mounted, such as a die pad which is a part of a lead frame, may be simply referred to as a substrate.

As illustrated in FIG 1, a semiconductor chip CP of the present embodiment has a rectangular shape in plan view. A first pad electrode (wiring) M3 is formed at an upper part of the semiconductor chip CP. A plurality of redistribution layers (RDL) RL are formed so as to be connected with the first pad electrode M3. On a part of an upper surface of each redistribution layer RL, a second pad electrode (bonding pad) PD is formed. Here, the second pad electrode PD is comprised of a metal film formed in contact with the upper surface of the redistribution layer RL. The redistribution layer RL is covered with the upper insulating film IF3 (not illustrated) except the part of the upper surface covered with the second pad electrode PD. An upper surface of the second pad electrode PD is exposed from the upper insulating film IF3.

Note that, in the present embodiment, the wiring M3 formed in a third wiring layer and connected with the redistribution layer RL is referred to as the first pad electrode M3, and an underlying metal film PD formed over the upper part of the redistribution layer RL may be referred to as the second pad electrode PD.

A lower insulating film IF2 having a rectangular shape in plan view is formed in a center part of the semiconductor chip CP. An insulating film IF1 having high moisture resistance is exposed from the lower insulating film IF2 on an upper surface of an outer peripheral portion of the semiconductor chip CP. That is, in plan view, the lower insulating film IF2 is formed so as to be surrounded by the annular insulating film IF1. As illustrated in FIG 2, the lower insulating film IF2 is formed over the insulating film IF1, and the redistribution layer RL and a dummy redistribution layer DL are formed directly over the lower insulating film IF2. The dummy redistribution layer DL is a metal film covering an upper surface of an end of the lower insulating film IF2 and an upper surface of the insulating film IF1 surrounding the lower insulating film IF2, in plan view.

As illustrated in FIG 1, in the present embodiment, the dummy redistribution layer (dummy pattern) DL is formed along the outer peripheral portion (a peripheral edge portion, or the end) of the semiconductor chip CP in an annular shape so as to surround the plurality of redistribution layers RL. In other words, the dummy redistribution layer DL is formed in an annular shape along an outer peripheral portion (a peripheral edge portion, or an end) of a semiconductor substrate (not illustrated) constituting the semiconductor chip CP. In plan view, the insulating film IF1 is positioned outside the dummy redistribution layer DL, and the lower insulating film IF2 is positioned inside the dummy redistribution layer DL. The dummy redistribution layer DL is formed to overlap with the lower insulating film IF2 and the insulating film IF1 exposed from the lower insulating film IF2 so as to cover a boundary between the insulating film IF 1 and the lower insulating film IF2 in plan view.

Further, in plan view, a trench D1 is formed in a front surface of the insulating film IF1 outside the dummy redistribution layer DL. The trench D1 is an opening of the insulating film IF1 and is formed in an annular shape outside the dummy redistribution layer DL in plan view. The redistribution layer RL is connected with the wiring M3 (see FIG 2) formed below a layered film including the lower insulating film IF2 and the insulating film IF1 via a via illustrated by a broken line in FIG 1. In contrast, the dummy redistribution layer DL is not connected with any wiring.

As illustrated in FIG 2, the semiconductor chip CP has a semiconductor substrate SB. Metal insulator semiconductor field effect transistors (MISFET) Q1 and Q2 each having a gate electrode formed on a main surface and a source/drain region formed in the main surface are formed in the vicinity of the main surface of the semiconductor substrate SB. Furthermore, although not illustrated, a semiconductor element such as a diode, a bipolar transistor, a capacitive element, a resistive element, or the like may be formed in the vicinity of the main surface of the semiconductor substrate SB.

The semiconductor substrate SB is comprised of, for example, high resistance single crystal silicon. An interlayer insulating film CL covering the gate electrode is formed over the semiconductor substrate SB. The interlayer insulating film CL is comprised of, for example, silicon oxide. Over the interlayer insulating film CL, a wiring M1 and an interlayer insulating film IL1 covering the wiring M1 are formed. The interlayer insulating film IL1 is comprised of, for example, silicon oxide, and the wiring M1 is mainly comprised of Cu (copper), for example. The wiring M1 is electrically connected with the MISFETs Q1 and Q2 via a contact plug PG penetrating through the interlayer insulating film CL.

Over the interlayer insulating film IL1, a wiring M2 and an interlayer insulating film IL2 covering the wiring M2 are formed. The interlayer insulating film IL2 is comprised of, for example, silicon oxide, and the wiring M2 is mainly comprised of Cu (copper), for example. The wiring M2 is electrically connected with the wiring M1 via a via VI penetrating through the interlayer insulating film IL1. The interlayer insulating film IL1, the wiring M1, and the via VI constitute a first wiring layer.

Over the interlayer insulating film IL2, a wiring M3 and an interlayer insulating film IL3 covering the wiring M3 are formed. The interlayer insulating film IL3 is comprised of, for example, silicon oxide, and the wiring M3 is mainly comprised of Cu (copper) or Al (aluminum), for example. The wiring M3 is electrically connected with the wiring M2 via a via V2 penetrating through the interlayer insulating film IL2. The interlayer insulating film IL2, the wiring M2, and the via V2 constitute a second wiring layer, and the interlayer insulating film IL3 and the wiring M3 constitute a third wiring layer. The first to the third wiring layers constitute a layered wiring layer formed over the semiconductor substrate SB.

Note that, in the present embodiment, the wiring M3 formed in an uppermost layer out of the first to the third wiring layers and connected with the redistribution layer RL may be referred to as the first pad electrode M3.

Also, a seal ring SLG including the wirings M1 to M3, the contact plug PG, and the vias V1 and V2 is formed over the main surface of the semiconductor substrate SB in the vicinity of the outer peripheral portion (end) of the semiconductor chip CP. The seal ring SLG includes the contact plug PG, the wiring M1, the via V1, the wiring M2, the via V2, and the wiring M3 which are layered in a direction perpendicular to the main surface of the semiconductor substrate SB in order, and is formed in an annular shape along an outer periphery of the semiconductor chip CP in plan view.

The seal ring SLG is provided for preventing a crack generated at the end of the semiconductor chip CP by dicing a scribe region (scribe line) of a semiconductor wafer (semiconductor substrate SB) from extending to a region closer to the center part than the vicinity of the end of the semiconductor chip CP when forming the plurality of individual diced semiconductor chips CP. Therefore, in the semiconductor chip CP, an element and a wiring constituting a circuit are not arranged outside the seal ring SLG The seal ring SLG is connected with the semiconductor substrate SB, but does not constitute a circuit in the semiconductor chip CP.

Note that the seal ring SLG may not include the wirings M1 to M3 but may only include the contact plug PG and the vias V1 and V2. Since the seal ring SLG is in an annular shape formed in plan view, the contact plugs PG and the vias VI and V2 constituting the seal ring SLG are formed in a wall shape extending along the main surface of the semiconductor substrate SB.

Over the interlayer insulating film IL3, the insulating film IF1 comprised of a material having high moisture resistance (for example, silicon nitride) is formed, and the lower insulating film IF2 is formed over the insulating film IF 1. In the vicinity of the outer peripheral portion of the semiconductor chip CP, the upper surface of the insulating film IF1 is exposed from the lower insulating film IF2. A part of the dummy redistribution layer DL and the redistribution layer RL are formed directly over the lower insulating film IF2. In other words, the part of the dummy redistribution layer DL is formed directly over the lower insulating film IF2 between the end of the semiconductor chip CP, that is, the end of the semiconductor substrate SB, and the redistribution layer RL.

The other part of the dummy redistribution layer DL is formed directly over the insulating film IF1 exposed from the lower insulating film IF2. That is, the dummy redistribution layer DL is formed from a region directly over the insulating film IF1 exposed from the lower insulating film IF2 to a region directly over the lower insulating film IF2. The redistribution layer RL and the dummy redistribution layer DL are uppermost-layer wirings out of the wirings formed over the semiconductor substrate SB.

The redistribution layer RL and the dummy redistribution layer DL each include a barrier metal film BM and a main conductor film MF which are formed in order over the insulating film IF1 and the lower insulating film IF2. The main conductor film MF is a metal film comprised of, for example, Cu (copper). The barrier metal film BM is a conductor film containing, for example, Ti (titanium), TiN (titanium nitride), Cr (chromium), or Ta (tantalum) and has a function of preventing copper forming the main conductor film MF over the barrier metal film BM from diffusing into the insulating film IF1.

The lower insulating film IF2 is comprised of an organic insulating film such as polyimide, for example. The layered film including the insulating film IF1 and the lower insulating film IF2 is opened directly under the redistribution layer RL, and a part of the redistribution layer RL is buried in the opening. Further, at the bottom of the opening, the redistribution layer RL and an upper surface of the wiring M3 which is an uppermost-layer wiring in the layered wiring layer are connected with each other. The wiring M3 connected with the redistribution layer RL is electrically connected with a semiconductor element (for example, the MISFETs Q1 and Q2) formed in the vicinity of the main surface of the semiconductor substrate SB via the vias V1 and V2, the wirings M1 and M2, and the contact plug PG That is, the redistribution layer RL constitutes a circuit

In contrast, the dummy redistribution layer DL is not electrically connected with the wiring M1 to M3 or the like and does not constitute a circuit in the semiconductor chip CP. That is, the dummy redistribution layer DL is a pseudo wiring. However, the dummy redistribution layer DL may be connected with the wiring M3 constituting the seal ring SLG Even in this case, the dummy redistribution layer DL does not constitute a circuit.

The trench D1 is formed in the upper surface of the insulating film IF1 in the vicinity of the outer peripheral portion of the semiconductor chip CP. Here, the trench D1 penetrates through the interlayer insulating film IL3 from the upper surface of the insulating film IF1 and reaches an upper surface of the interlayer insulating film IL2. Note that the trench D1 may be formed deeper or may be formed shallower. The trench D1 is provided to prevent the crack generated at the end of the semiconductor chip CP in the above-mentioned dicing process from extending to the region closer to the center part than the outer peripheral portion of the semiconductor chip CP. Note that the trench D1 may not be formed.

The trench D1 is formed in the region closer to the outer peripheral portion of the semiconductor chip CP than the seal ring SLG. In plan view, the lower insulating film IF2, the redistribution layer RL, and the dummy redistribution layer DL are each formed on a side closer to the center part of the semiconductor chip CP than the trench D1 and the seal ring SLG. Therefore, the trench D1 is not covered with the lower insulating film IF2, the redistribution layer RL, or the dummy redistribution layer DL. Further, the lower insulating film IF2 terminates at a position closer to a center of the semiconductor chip CP in plan view than the region directly above the seal ring SLG However, the dummy redistribution layer DL may be formed directly above the seal ring SLG That is, an end of the dummy redistribution layer DL on a side of a scribe region 1B is positioned inside or directly above the seal ring SLG

Metal films PM1 and PM2 are layered in order over the upper surface of a part of the redistribution layer RL, and the layered film including the metal films PM1 and PM2 constitutes the second pad electrode PD. The metal film PM1 is comprised of, for example, Ni (nickel), and the metal film PM2 is comprised of, for example, Au (gold) or palladium (Pd) or an alloy thereof. The second pad electrode PD is in contact with the upper surface of the part of the redistribution layer RL so as to cover the upper surface thereof

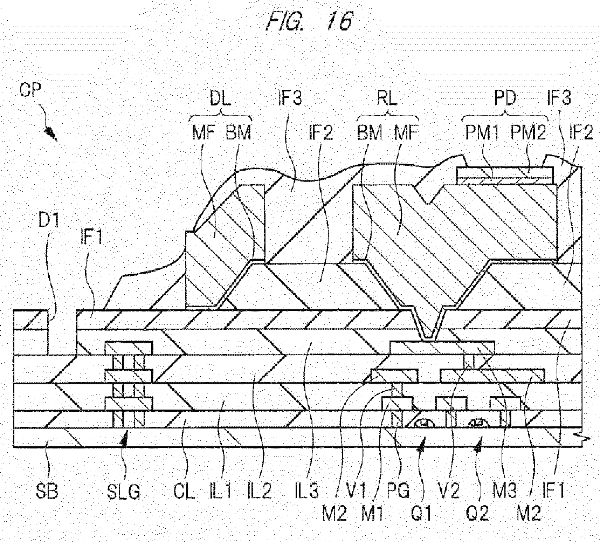

Over the insulating film IF1, the lower insulating film IF2, the redistribution layer RL, and the dummy redistribution layer DL, the upper insulating film IF3 comprised of, for example, polyimide is formed. The upper surface and a side wall of the redistribution layer RL in a portion exposed from the second pad electrode PD are covered with the upper insulating film IF3. Further, a side wall and the upper surface of the dummy redistribution layer DL are all covered with the upper insulating film IF3. Note that, as will be described later with reference to FIG 16, a part of the upper surface and the side wall of the dummy redistribution layer DL may be exposed from the upper insulating film IF3. However, at least the side wall of the dummy redistribution layer DL, which is adjacent to the redistribution layer RL and faces the side wall of the redistribution layer RL is covered with the upper insulating film IF3 directly above the lower insulating film IF2.

An end of the upper insulating film IF3 is formed inside the trench D1 in plan view and is not formed outside the trench D1. That is, the upper insulating film IF3 exposes the trench D1. That is, the upper insulating film IF3 terminates at a position closer to the center of the semiconductor chip CP in plan view than the trench D1. Here, a part of the upper insulating film IF3 is formed directly above the seal ring SLG

In the semiconductor chip CP, the lower insulating film IF2, the redistribution layer RL, and the upper insulating film IF3 are not formed outside the trench D1, that is, on a side of the end of the semiconductor chip CP. In a case where the lower insulating film IF2 and the redistribution layer RL are formed in a region (scribe line) cut in the dicing process in the manufacturing process of the semiconductor device, the lower insulating film IF2 and the redistribution layer RL each serve as a starting point of a chipping crack upon dicing. For this reason, the above configuration is made to prevent the occurrence of such a crack.

The upper insulating film IF3 has a function of protecting the redistribution layer RL constituting a circuit from moisture or the like. Therefore, except for the portion where the second pad electrode PD is formed, the upper insulating film IF3 covers the redistribution layer RL. Also, the upper insulating film IF3 is formed so as to bury a gap between the redistribution layer RL and the dummy redistribution layer DL which are adjacent to each other. The end of the lower insulating film IF2 is covered with the dummy redistribution layer DL and the upper insulating film IF3 because, when the end of the lower insulating film IF2 is exposed at the time of processing the upper insulating film IF3 by exposure and development, the end of the lower insulating film IF2 is dissolved by developing solution, and the lower insulating film IF2 may be peeled off.

As described with reference to FIG 1 and FIG 2, the semiconductor chip CP includes the semiconductor substrate SB, the MISFETs Q1 and Q2 which are the semiconductor elements each constituting a circuit, the layered wiring layer including the wirings M1 to M3 constituting a circuit, the insulating film IF1, the lower insulating film IF2, the redistribution layer RL, the dummy redistribution layer DL, and the upper insulating film IF3. As a modification example of the semiconductor device of this embodiment, a structure in which the seal ring SLG or the trench D2 is not formed is also conceivable.

FIG 3 is a cross-sectional view of a structure in which the semiconductor chip CP of the present embodiment is mounted on a substrate PSB and sealed with an insulating film.

It is preferable that the redistribution layer RL is basically completely covered with the upper insulating film IF3. When a part of the redistribution layer RL is exposed from the upper insulating film IF3, the subject chip is determined to be a defect in an appearance inspection, and in addition, halogen ions or moisture from a resin as a mold resin reaches the redistribution layer RL quickly. As a result, oxidation or ionization of copper constituting the redistribution layer RL is promoted, and reliability against high temperature and high humidity is lowered, so that it becomes difficult to guarantee a long-term product life for automotive use or the like.

The substrate PSB is, for example, a printed circuit board. A wiring PW is formed over an upper surface of the substrate PSB, and the second pad electrode PD and the wiring PW are connected by an external connection terminal. In this embodiment, as the external connection terminal, for example, a bonding wire or a solder bump is exemplified. In this case, the second pad electrode PD and the wiring PW are electrically connected by a bonding wire BW That is, one end of the bonding wire BW is connected to the second pad electrode PD on an upper surface of the semiconductor chip CP, and the other end is connected to an upper surface of the wiring PW The semiconductor chip CP, the wiring PW, and the bonding wire BW are sealed with a sealing body (mold resin) MD and are not exposed.

In FIG 3, the sealing body MD is formed so as to cover a part of the upper surface of the substrate PSB, but the sealing body MD may be formed so as to cover the upper surface, a side wall and a lower surface of the substrate PSB. In this case, some of the bonding wires BW may have one ends exposed to the outside of the sealing body MD.

Further, the substrate PSB on which the semiconductor chip CP is mounted may be, for example, a die pad comprised of a metal plate. In this case, one end of the bonding wire BW is connected to the second pad electrode PD on the upper surface of the semiconductor chip CP, and the other end is connected in the sealing body MD to a lead which is a metal plate partly exposed from the sealing body.

Further, when the semiconductor chip CP is used as a flip chip and mounted (mounted) on the upper surface of the substrate PSB, it is conceivable to form a solder ball in contact with an upper surface of the second pad electrode PD, turn the semiconductor chip CP upside down, and connect the solder ball to the wiring PW on the upper surface of the substrate PSB.

Here, although the sealing body MD illustrated in FIG 3 is in contact with the upper insulating film IF3, the sealing body MD is not in contact with the redistribution layer RL and the lower insulating film IF2. In a case where a part of the dummy redistribution layer DL is exposed from the upper insulating film IF3, the sealing body MD may be in contact with the part of the dummy redistribution layer DL.

The redistribution layer RL illustrated in FIG 2 is a wiring which serves a function of rearranging a position where the second pad electrode for connecting a bonding wire, a solder ball, or the like is provided to the semiconductor chip. As an example of the structure of the semiconductor chip, it is conceivable that the dummy redistribution layer DL, the redistribution layer RL, the lower insulating film IF2, and the upper insulating film IF3 are not provided, the upper surface of the wiring M3 exposed from the insulating film IF1 is used as the second pad electrode, and the bonding wire, for example, is connected to the second pad electrode. In a case where a plurality of bonding wires are not brought into contact with one another but are appropriately spaced apart to be connected to the upper surface of the semiconductor chip, it is preferable that the second pad electrodes which are the respective connection portions of the plurality of bonding wires are sufficiently separated from one another.

However, arranging the second pad electrodes on the upper surface of the wiring M3 sufficiently apart may be difficult due to a design of layout of the wiring M3. In such a case, the redistribution layer RL is used to rearrange the position of the second pad electrode. As illustrated in FIG 1, the second pad electrodes PD drawn out by the redistribution layer RL are arranged in a matrix in plan view. By arranging the positions of the second pad electrodes PD regularly in a matrix using the redistribution layers RL in this manner, easy connection of the bonding wires is facilitated. Further, when the solder ball is connected to the second pad electrode PD, the positions of the second pad electrodes PD are regularly arranged by using the redistribution layers RL, so that connection strength between the semiconductor chip CP and the object to be connected with the semiconductor chip CP can be increased.

Note that, in the present embodiment, as the second pad electrode PD, the layered film including the metal films PM1 and PM2 formed over the redistribution layer RL is used; however, the second pad electrode PD may be formed so as to directly bring the metal film PM2 into contact with the upper surface of the redistribution layer RL without being provided with the metal film PM1. Further, instead of forming the metal films PM1 and PM2, a part of the upper surface of the redistribution layer RL may be used as the second pad electrode, and a bonding wire, a solder ball, or the like may be directly bonded to the part of the upper surface.

Therefore, the second pad electrode is formed over the upper surface of the redistribution layer RL exposed from the upper insulating film IF3 illustrated in FIG 2 or directly over the upper surface. In the present application, the metal films PM1 and PM2 provided over the redistribution layer RL for reducing connection resistance to the bonding wire and the like and for protecting the redistribution layer RL are referred to as the second pad electrodes PD. However, the upper surface of the redistribution layer RL exposed from the upper insulating film IF3 illustrated in FIG 2 also constitutes the second pad electrode.

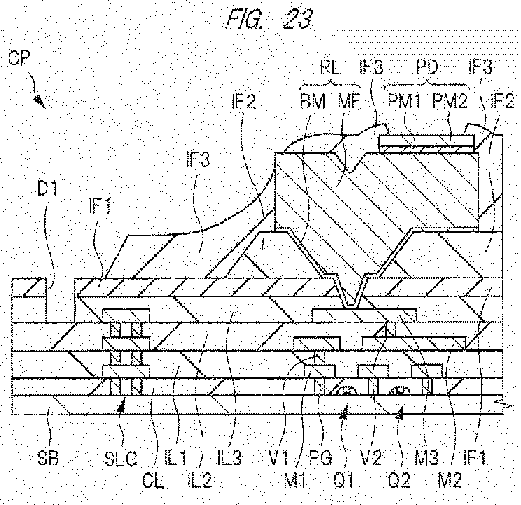

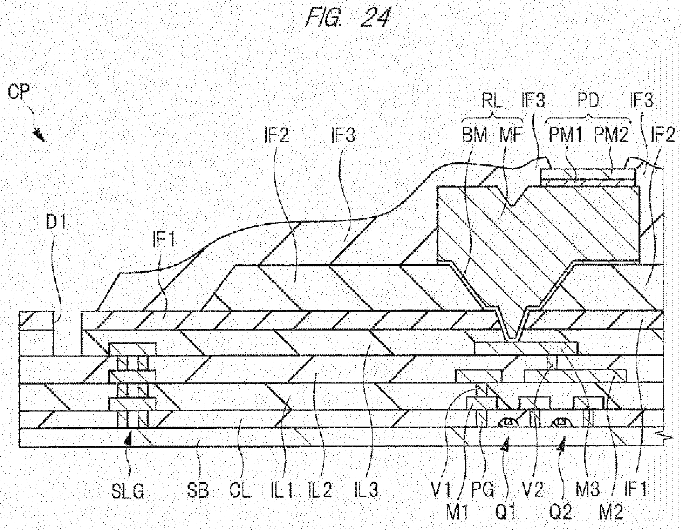

Next, the effects of the semiconductor device of this embodiment will be described with reference to a comparative example illustrated in FIG. 23 and FIG. 24. FIG. 23 and FIG. 24 are cross-sectional views each illustrating an end of a semiconductor chip which is a semiconductor device of the comparative example.

In the comparative example illustrated in FIG. 23, unlike the semiconductor chip CP illustrated in FIG. 2, a dummy redistribution layer DL is not provided. That is, no other wiring is formed over a lower insulating film IF2 between a redistribution layer RL and a terminal portion of the lower insulating film IF2. Therefore, an upper insulating film IF3 is continuously formed in contact with each of a side wall of the redistribution layer RL, an upper surface of the lower insulating film IF2, a side wall of the lower insulating film IF2, and an upper surface of an insulating film IF 1.

In this case, the upper insulating film IF3 is formed of a film formed by coating in the manufacturing process of the semiconductor device. In the coating method, for example, by supplying polyimide having low viscosity to a main surface of a wafer from above the rotating wafer and casting the polyimide by centrifugal force of the rotating wafer, an upper surface of the wafer is covered with the polyimide. Liquid polyimide having low viscosity has a small film thickness over the redistribution layer RL. Meanwhile, since the liquid comprised of polyimide accumulates in a region between the adjacent redistribution layers RL, the thickness of the polyimide film in that region becomes great

The liquid polyimide is solidified by sintering after coating to form the upper insulating film IF3 comprised of the solidified polyimide film. The thickness of the polyimide film is set so as to completely cover the plurality of redistribution layers RL and the second pad electrodes PD each formed in close contact with the upper surface of a part of each of the redistribution layers RL. The film thickness of the polyimide film is controlled, for example, by controlling viscosity of the liquid polyimide. However, in the semiconductor device of the comparative example, in plan view, it is difficult to completely cover the redistribution layer adjacent at an end of the semiconductor chip CP with the upper insulating film IF3 for the following reason.

As illustrated in FIG. 23, no other wiring is formed between the redistribution layer RL formed outermost in the semiconductor chip CP in plan view and the end of the semiconductor chip CP. Therefore, in the manufacturing process of the semiconductor device, there is no region where the liquid polyimide accumulates on a side closer to the end of the semiconductor chip CP than the redistribution layer RL.

Furthermore, in order to prevent a crack from extending into the semiconductor chip CP upon dicing, the lower insulating film IF2 and the redistribution layer RL are not formed on the side closer to the end of the semiconductor chip CP than the trench D1. That is, in the manufacturing process of the semiconductor device, directly before the process of coating the above polyimide, the trench D1 and the insulating film IF1 are exposed in the vicinity of an end of a semiconductor element formation region and in a front surface on an upper side of a scribe region.

Since liquid polyimide tends to flow toward a lower side, the polyimide coated on a side closer to the end of the semiconductor element formation region than the redistribution layer RL flows to a scribe region where the upper surface of the insulating film IF1 is exposed and a region on a side of an end of the semiconductor chip forming region, that is, a region where a height is low. In addition, since the trench D1 is also formed in the upper surface of the insulating film IF1 at the end of the semiconductor element formation region, the polyimide also flows into the trench D1.

As a result, the polyimide is formed so as to extend thinly from the redistribution layer RL to the end of the semiconductor chip CP and the scribe region. Note that, in the manufacturing process of the semiconductor device, the polyimide film is partly removed by lithography and then polymerized by sintering to be fixed. Accordingly, the upper insulating film IF3 including the polyimide film terminates at a position closer to the center of the semiconductor chip CP in plan view than the trench D1.

In the comparative example, since the redistribution layer RL and a terminal portion of the lower insulating film IF2 are close to each other, a step having a height difference from a height of an upper surface of the redistribution layer RL to a height of the upper surface of the insulating film IF1 is formed at an end of a layered film including the redistribution layer RL and the lower insulating film IF2. The term "step" as used herein is a surface shape of a layered film including the redistribution layer RL, the lower insulating film IF2, and the insulating film IF1, and refers to a shape having a height difference generated between the upper surface of the redistribution layer RL and a bottom surface of a region adjacent to the side wall of the redistribution layer RL, or the height difference therebetween. Also, in a case where the trench D1 is formed in the vicinity of the redistribution layer RL, a bottom portion of the step is positioned on a bottom surface of the trench D1.

When the liquid polyimide is coated to form the upper insulating film IF3 in such a state that such a large step is formed, most of the polyimide supplied in the vicinity of the step flows down to a lower portion of the step. For this reason, a film thickness of the upper insulating film IF3 comprised of polyimide becomes smaller in an upper portion of the large step as described above. That is, the film thickness of the upper insulating film IF3 becomes small in the vicinity of the side wall of the redistribution layer RL constituting the step, and in particular, the film thickness of the upper insulating film IF3 becomes remarkably small in the vicinity of an upper end of the side wall of the redistribution layer RL. Note that the term "film thickness" as used herein refers to a film thickness in a direction perpendicular to an underlying surface of the predetermined film. For example, the film thickness of the upper insulating film IF3 covering the side wall of the redistribution layer RL refers to the thickness of the upper insulating film IF3 in a direction perpendicular to the side wall.

In a region where the film thickness of the upper insulating film IF3 is small as described above, a part of the redistribution layer RL is likely to be exposed from the upper insulating film IF3 on a side closer to the trench D1, that is, on an upper part of the side wall on the side of the end of the semiconductor chip CP, of the side walls of the redistribution layer RL. That is, a corner portion of a boundary between the side wall of the redistribution layer RL facing one side of the end of the semiconductor chip CP in plan view, and the upper surface of the redistribution layer RL is exposed from the upper insulating film IF3.

In a case where a part of the redistribution layer RL constituting a circuit is exposed from the upper insulating film IF3 due to manufacturing variations, that is, variations in manufacturing accuracy such as film formation or processing in the manufacturing process, the following problem occurs. That is, the redistribution layer RL in a portion exposed from the upper insulating film IF3 causes defective appearance of the semiconductor chip CP.

Furthermore, since a mold resin which is a coating material of the semiconductor chip CP and the redistribution layer RL are brought into contact with each other, halogen ions or moisture in the mold resin reach the redistribution layer RL quickly. As a result, oxidation and ionization of Cu (copper) constituting the redistribution layer RL are promoted, so that reliability of the semiconductor device against environment of high temperature and high humidity deteriorates. In particular, it is difficult to guarantee the long-term product life of the semiconductor chip CP and the like for automotive use.

The above problem becomes more conspicuous in a case where the redistribution layer becomes thicker in the future from demand of reducing resistance of the redistribution layer. In addition, the above problem becomes conspicuous also in a case where an interval (wiring pitch) between the redistribution layers is reduced in order to miniaturize the semiconductor device, and thinning of the upper insulating film is progressed. This is because it is necessary to further lower the viscosity of the polyimide in order to fully bury a space between the redistribution layers by the upper insulating film IF3 when the interval between the redistribution layers having a great film thickness is small.

As a method of preventing the redistribution layer RL from being exposed, a method of setting the film thickness of the redistribution layer RL to be small or a method of setting the film thickness of the upper insulating film IF3 to be great can be considered. Alternatively, as another method, as illustrated in FIG. 24, it is conceivable to increase an interval between the redistribution layer RL arranged outermost in the redistribution layers RL in the semiconductor chip CP and the terminal portion of the lower insulating film IF2 by largely extending the lower insulating film IF2 toward a side closer to the end of the semiconductor chip CP than the redistribution layer RL. That is, if the redistribution layer RL and the terminal portion of the lower insulating film IF2 are separated from each other, a step in the vicinity of the side wall of the redistribution layer RL is reduced to a height from the upper surface of the redistribution layer RL to the upper surface of the lower insulating film IF2; therefore, it is possible to stabilize the film thickness of the upper insulating film IF3 in the vicinity of the end of the semiconductor chip CP and to prevent the thinning of the polyimide film in contact with the side wall of the redistribution layer RL.

However, when the redistribution layer RL is thinned, a resistance value of the redistribution layer RL is remarkably increased. Therefore, this thinning hinders power saving and high speed operation of the semiconductor device and also causes abnormal operation of the semiconductor device. In this case, in a direction along the main surface of the semiconductor substrate SB, a width of a region (seal ring region) from the redistribution layer RL closest to the end of the semiconductor chip CP to an end of the seal ring SLG on a side of the trench D1 is, for example, 34 to 49 µm. A width of the seal ring SLG in the same direction is, for example, 4 µm. In the same direction, a distance from the redistribution layer RL closest to the end of the semiconductor chip CP to the trench D1 is, for example, 50 µm.

In addition, if it is attempted to coat polyimide formed to be coated so as to have a greater thickness than a certain thickness, the film thickness uniformity and burying property become poor. That is, in order to increase the thickness of the polyimide film, it is necessary to increase the viscosity of the polyimide. However, when a highly viscous polyimide is used, it is difficult to bury a space between adjacent redistribution layers RL at small intervals and to form the upper insulating film IF3 with a uniform film thickness over the entire surface on the main surface side of the semiconductor wafer.

Further, as illustrated in FIG 24, in a case where the interval between the redistribution layer RL and the terminal portion of the lower insulating film IF2 is increased, it is necessary to provide a large region where the redistribution layer RL cannot be arranged, between the redistribution layer RL and the end of the semiconductor chip CP, so that a chip area increases, making it difficult to miniaturize the semiconductor device. As a result, the number of chips acquired per wafer decreases. That is, there arises a problem that the manufacturing cost increases.

Therefore, in the semiconductor device of the comparative example described with reference to FIG. 23 and FIG. 24, it is difficult to prevent the redistribution layer RL constituting a circuit from being exposed from the upper insulating film IF3 and realize miniaturization of the semiconductor device.

Note that it is also conceivable to prevent the redistribution layer RL from being exposed from the upper insulating film IF3 by forming the upper insulating film IF3 by deposition (for example, the CVD (chemical vapor deposition)) rather than coating. However, the insulating film formed by deposition has higher hardness than the film formed by coating, and has low adhesion to the sealing body (mold resin) MD (see FIG. 3) covering the semiconductor chip CP. Therefore, it is difficult to adopt the deposition method as a method of forming the upper insulating film IF3 from the viewpoint of securing the reliability of the semiconductor device.

The film thickness of the upper insulating film becomes smaller as described above using the comparative example further outside the redistribution layer positioned on the outermost side in the semiconductor chip in plan view. In contrast, even in the vicinity of the end of the semiconductor chip, the film thickness of the upper insulating film buried between the redistribution layer and another redistribution layer adjacent to the redistribution layer is equal to the thickness of the upper insulating film between the redistribution layers in the center part of the semiconductor chip in plan view.

Therefore, in the semiconductor device of the present embodiment, as illustrated in FIG. 1 and FIG. 2, the dummy redistribution layer DL which does not constitute a circuit is provided directly over the lower insulating film IF2 between the redistribution layer RL and the end of the semiconductor chip CP. Accordingly, the height difference of the step of the redistribution layer RL close to the end of the semiconductor chip CP is a size from the upper surface of the redistribution layer RL to the upper surface of the lower insulating film IF2 and is smaller than the step illustrated in the comparative example of FIG. 23. Also, between the redistribution layer RL and the dummy redistribution layer DL which are adjacent to each other, the liquid upper insulating film IF3 accumulates upon formation, so that the film thickness of the upper insulating film IF3 is increased. That is, the film thickness of the upper insulating film IF3 formed at the step is increased.

Therefore, it is possible to prevent the film thickness of the upper insulating film IF3 from decreasing in the vicinity of the upper corner portion of the side wall of the redistribution layer RL, that is, the side wall on the side of the end of the semiconductor chip CP. Therefore, the thickness of the upper insulating film IF3 in the vicinity of the end of the semiconductor chip CP can be stabilized.

Thereby, it is possible to prevent the corner portion of the redistribution layer RL from being exposed from the upper insulating film IF3. That is, the redistribution layer RL can be completely covered with the upper insulating film IF3 except for a region where the second pad electrode PD is formed. Therefore, it is possible to prevent defective appearance due to exposure of the redistribution layer RL, and deterioration of the redistribution layer RL due to moisture or the like. As in the present embodiment, by forming the dummy redistribution layer DL as a pseudo wiring for adjusting the film thickness of the upper insulating film IF3, the reliability of the semiconductor device can be secured.

Furthermore, if the dummy redistribution layer DL is provided as described above, it is possible to prevent the film thickness of the upper insulating film IF3 from decreasing at the corner portion of the upper surface of the redistribution layer RL without providing a wide region where the redistribution layer RL is not formed in the vicinity of the end of the semiconductor chip CP as in the comparative example illustrated in FIG. 24. Therefore, an increase in area of the semiconductor chip CP can be prevented. That is, in the present embodiment, there is no need to provide an arrangement prohibition region of the redistribution layer RL that is set in a wide range in the comparative example.

In this case, in the direction along the main surface of the semiconductor substrate SB, a width of a region (seal ring region) from the redistribution layer RL closest to the end of the semiconductor chip CP to the end of the seal ring SLG on the side of the trench D1 is, for example, 16 to 33 µm. That is, for example, a width from the dummy redistribution layer DL in the same direction to the end of the seal ring SLG on the side of the trench D1 is 6 µm, a width of the dummy redistribution layer DL in the same direction is 5 to 12 µm, and a distance between the dummy redistribution layer DL and the redistribution layer RL in the same direction is 5 to 15 µm.

Therefore, it is possible to reduce the chip area, which makes it easier to miniaturize the semiconductor chip CP. Accordingly, it is possible to suppress the manufacturing cost of the semiconductor device. Therefore, improvement of reliability of semiconductor device and suppression of manufacturing cost can be achieved at the same time.

Further, in the present embodiment, as illustrated in FIG. 2, the dummy redistribution layer DL is formed between a portion directly over the lower insulating film IF2 and a portion directly over the insulating film IF1 exposed from the lower insulating film IF2. That is, the dummy redistribution layer DL continuously covers the upper surface and the side wall of the lower insulating film IF2 and the upper surface of the insulating film IF 1.

Here, since a part of the dummy redistribution layer DL is formed directly over the insulating film IF1 exposed from the lower insulating film IF2, in a region where the dummy redistribution layer DL and the lower insulating film IF2 do not overlap in plan view, a step between a height of the upper surface of the dummy redistribution layer DL and a height of the upper surface of the insulating film IF1 is equal to a film thickness of the dummy redistribution layer DL and is smaller than the step described with reference to FIG. 23. Therefore, the dummy redistribution layer DL is completely covered with the upper insulating film IF3 in the same manner as the redistribution layer RL (not illustrated) inside the semiconductor chip CP.

In addition, the side wall of the lower insulating film IF2 has a tapered shape and is formed obliquely. The dummy redistribution layer DL covers the end including the side wall of the lower insulating film IF2 and is formed so as to straddle the insulating film IF1 and the lower insulating film IF2. In other words, the dummy redistribution layer DL is formed over the insulating film IF1 so as to ride on a step formed by the end of the lower insulating film IF2. Therefore, a step is also formed on the upper surface of the dummy redistribution layer DL. However, since a height difference of the step on the upper surface of the dummy redistribution layer DL is equal to a thickness of the lower insulating film IF2 and is obliquely formed along the tapered shape of the end of the lower insulating film IF2, the dummy redistribution layer DL is not exposed from the upper insulating film IF3.

Since the dummy redistribution layer DL is completely covered with the upper insulating film IF3, it is possible to obtain an effect of improving image recognition accuracy at the time of appearance inspection of the semiconductor chip CP.

### <Method of Manufacturing Semiconductor Device>

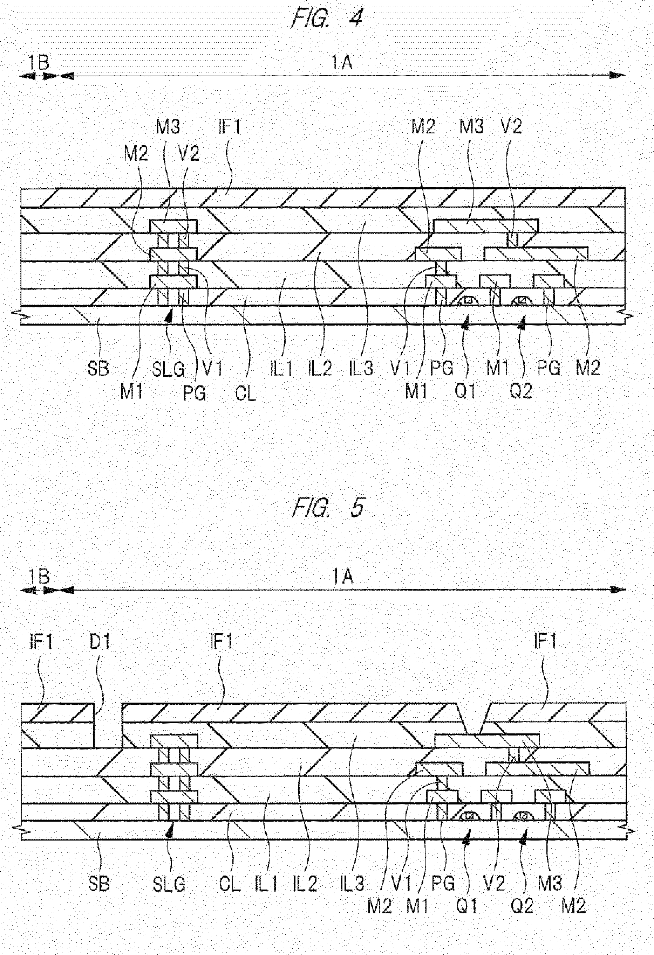

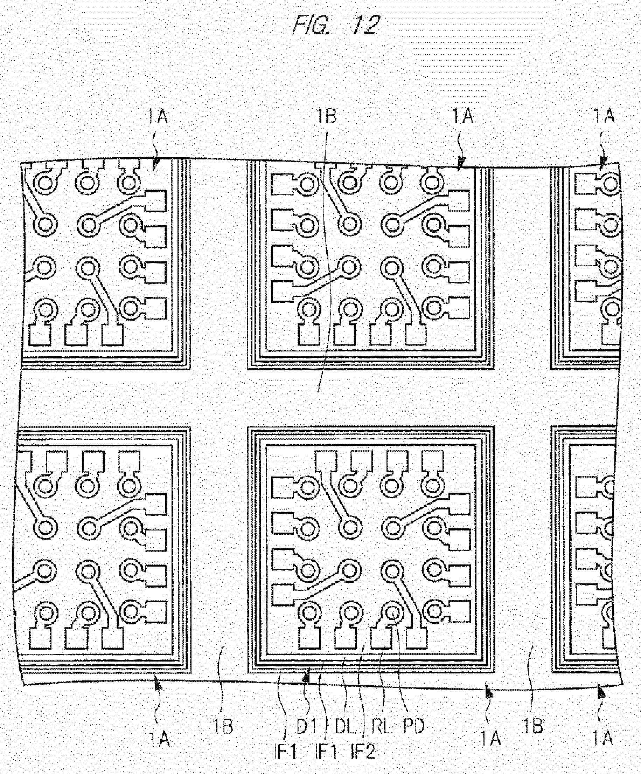

A method of manufacturing a semiconductor device according to the present embodiment will be described with reference to FIG. 4 to FIG. 15. FIG. 4 to FIG. 11 and FIG. 13 to FIG. 15 are cross-sectional views of the semiconductor device according to the present embodiment during a manufacturing process. FIG. 12 is a plan view of the semiconductor device of the present embodiment during the manufacturing process. In FIG. 4 to FIG. 11, FIG. 13, and FIG. 14, an element formation region 1A is illustrated on the right side of each drawing, and the scribe region 1B is illustrated on the left side. The element formation region 1A is a region that remains as a semiconductor chip after a dicing process described later, and in the dicing process, the scribe region 1B is a region removed by cutting the semiconductor substrate SB and films directly over the semiconductor substrate SB.

Note that a case where the layered wiring layer includes three wiring layers will be described herein, but the number of wiring layers to be layered may be smaller or larger than three layers. In addition, since a main feature of the present embodiment is the structure above the layered wiring layer and a method of manufacturing the same, description of a specific manufacturing method of a semiconductor element formed in the vicinity of the main surface of the semiconductor substrate is omitted.

In a manufacturing process of a semiconductor device, first, as illustrated in FIG. 1, a semiconductor substrate (semiconductor wafer) SB comprised ofp-type single crystal silicon (Si) or the like having a specific resistance of 1 to 10 Ωcm, for example, is prepared. Then, in the main surface of the semiconductor substrate SB, a plurality of element isolation regions defining an active region is formed (not illustrated). The element isolation region is formed, for example, by burying an insulating film mainly including a silicon oxide film in a trench of the main surface of the semiconductor substrate SB.

Subsequently, after an impurity is introduced into the main surface of the semiconductor substrate SB to form a well (not illustrated), MISFETs Q1 and Q2 including a gate electrode formed on the main surface of the semiconductor substrate SB via a gate insulating film and source/drain regions formed in the main surface of the semiconductor substrate SB are formed.

Subsequently, after an interlayer insulating film CL covering the MISFETs Q1 and Q2 is formed over the entire main surface of the semiconductor substrate SB, an upper surface of the interlayer insulating film CL is polished by the CMP (chemical mechanical polishing) or the like. The interlayer insulating film CL includes, for example, a silicon oxide film, and can be formed by, for example, the CVD or the like. Thereafter, a plurality of contact holes penetrating through the interlayer insulating film CL are formed by photolithography and dry etching. Thereafter, a contact plug PG including a metal film (for example, W (tungsten) film) burying each contact hole is formed. The contact plug PG is connected to the MISFET Q1 or Q2 or the like.

In this case, a contact plug PG constituting a seal ring to be formed later is also formed in a region which is an end of the element formation region 1A and close to the scribe region 1B. The contact plug PG penetrates through the interlayer insulating film CL and is connected to the main surface of the semiconductor substrate SB.

Subsequently, a first wiring layer including a first-layer wiring M1 is formed over the interlayer insulating film CL in which the contact plug PG is buried. The wiring M1 can be formed by, for example, forming an Al (aluminum) film over the interlayer insulating film CL by sputtering and then processing the Al film by photolithography and dry etching. The wiring M1 may be formed of, for example, a Cu (copper) film. Further, the wiring M1 can be formed by using the so-called damascene technique. A plurality of the first-layer wirings M1 are each connected to an upper surface of each of the contact plug PG In this case, on the contact plug PG at the end of the element formation region 1A, a wiring M1 constituting a seal ring to be formed later is also formed. Note that the same applies to wirings M2 and M3.

Subsequently, an interlayer insulating film IL1 is formed over the interlayer insulating film CL so as to cover the wiring M1, for example, by the CVD, and then, an upper surface of the interlayer insulating film IL1 is planarized by the CMP, for example. Thereafter, a via hole is formed by opening the interlayer insulating film IL1 by photolithography and dry etching, whereby an upper surface of the wiring M1 is exposed at a bottom of the via hole. Thereafter, a via V1 for burying the via hole is formed with, for example, a W (tungsten) film or the like. The via V1 is connected to the upper surface of the wiring M1. As a result, the first wiring layer including the wiring M1, the interlayer insulating film IL1, and the via V1 is formed.

Subsequently, a second wiring layer over the first wiring layer and a third wiring layer over the second wiring layer are sequentially formed by the same method as the first wiring layer. A wiring M3 constituting the third wiring layer is electrically connected with a wiring M2 via a via V2 in the via hole formed in an interlayer insulating film IL2. The wiring M2 constituting the second wiring layer is electrically connected with the wiring M1 via the via V1. In this case, the wiring M3 is formed of an Al film, and is covered with an interlayer insulating film IL3 including, for example, a silicon oxide film.

Further, a via is not formed on the wiring M3. In addition, a seal ring SLG including the contact plug PG, the vias V1 and V2, and the wirings M1 to M3 is formed at the end of the element formation region 1A. The contact plugs PG, the vias V1 and V2, and the wirings M1 to M3 which are electrically connected with the element such as the MISFET Q1 or Q2 constitute a circuit, whereas the seal ring SLG is not electrically connected with an element such as the MISFET Q1 or Q2 and does not constitute a circuit The seal ring SLG is in an annular shape formed along the outer periphery of the element formation region 1A having a rectangular shape in plan view. Inside the seal ring SLG having an annular layout, wirings constituting a circuit and semiconductor elements are formed.

Subsequently, an insulating film IF1 is formed over the interlayer insulating film IL3 by, for example, the CVD. The insulating film IF1 includes, for example, a silicon nitride film, and has higher moisture resistance than a silicon oxide film or the like.

Also, although not illustrated in detail, the wiring M3 is formed to have a greater film thickness than the wirings M1 and M2 and is formed to have a smaller film thickness than the redistribution layer RL described later. As described above, the wirings M1 to M3 may be formed of the same material, but it is also possible to form the wirings M1 and M2 with a copper wiring and the wiring M3 serving as a first pad electrode with an aluminum wiring.

Next, as illustrated in FIG. 5, the insulating film IF1 and the interlayer insulating film IL3 are opened (a first opening) by photolithography and dry etching. As a result, a part of an upper surface of the wiring M3 is exposed. Also, in this etching process, in the direction along the main surface of the semiconductor substrate SB, the insulating film IF1 and the interlayer insulating film IL3 at a position closer to a boundary between the element formation region 1A and the scribe region 1B than the seal ring SLG are opened to form a trench D1. On a bottom surface of the trench D1, a part of an upper surface of the interlayer insulating film IL2 is exposed. However, a formation depth of the trench D1 may be up to an intermediate depth of the interlayer insulating film IL3, for example.

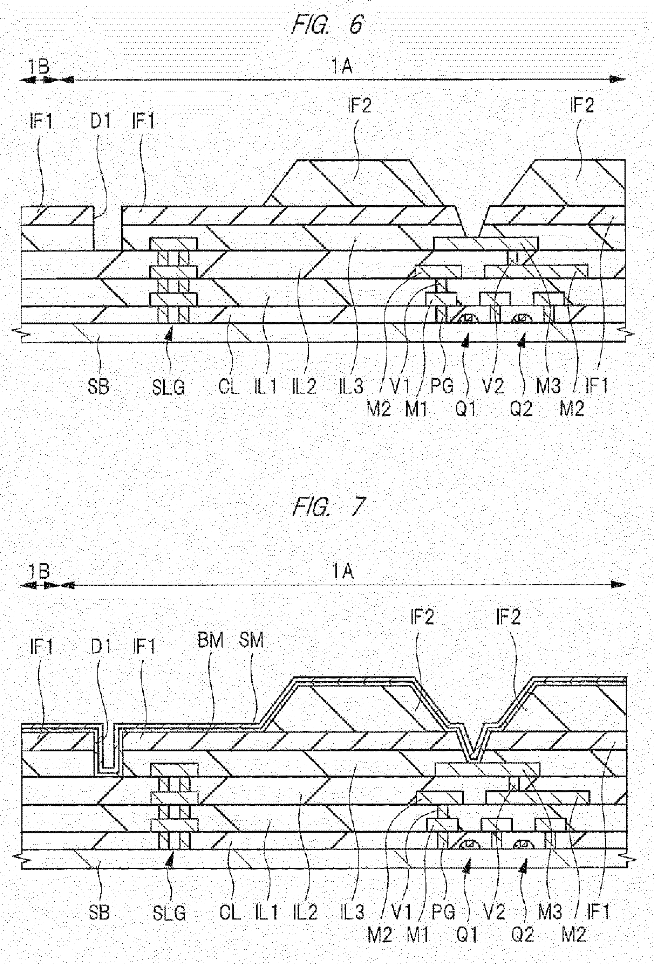

Next, as illustrated in FIG. 6, after a photosensitive film (for example, a polyimide film) is formed over the semiconductor substrate SB by coating, the lower insulating film IF2 is subjected to exposure and development, so that the lower insulating film IF2 is patterned to form an opening (a second opening). Thereafter, the film is solidified by sintering, thereby forming the lower insulating film IF2. Thereafter, here, by removing the lower insulating film IF2 directly on the opening which is the first opening penetrating through the interlayer insulating film IL3 and the insulating film IF1, that is, the opening exposing the upper surface of the wiring M3 constituting a circuit, the upper surface of the wiring M3 is exposed. That is, the second opening having a larger diameter than the first opening of the insulating film IF1 is formed in the insulating film IF2.

In addition, here, the lower insulating film IF2 at the end of the element formation region 1A and in the scribe region 1B are removed. As a result, the trench D1, the insulating film IF1 directly above the seal ring SLG and the insulating film IF1 in the scribe region 1B are exposed from the lower insulating film IF2. That is, the lower insulating film IF2 remains only inside the seal ring SLG having the annular layout in plan view.

Next, as illustrated in FIG. 7, a barrier metal film BM and a seed metal film SM are sequentially formed over the semiconductor substrate SB, for example, by sputtering. The barrier metal film BM is a conductor film containing, for example, Ti (titanium), TiN (titanium nitride), Cr (chromium), or Ta (tantalum), and the seed metal film SM is comprised of, for example, Cu (copper). A layered film including the barrier metal film BM and the seed metal film SM covers the insulating film IF1, the lower insulating film IF2, and the side wall of the interlayer insulating film IL3, a part of the upper surface of the interlayer insulating film IL2, and a part of the upper surface of the wiring M3.

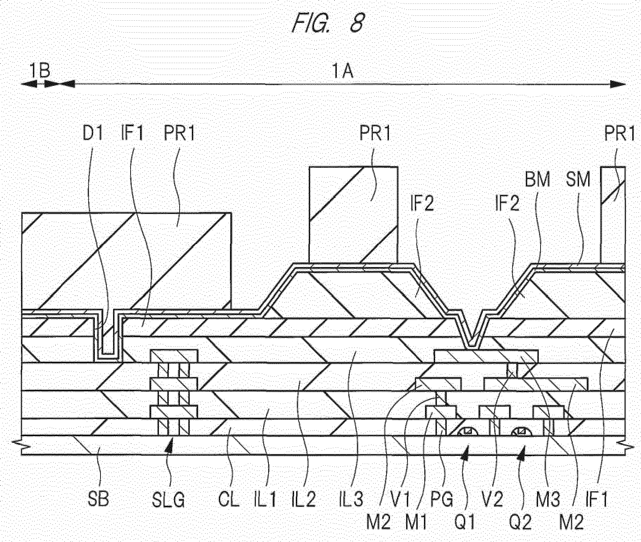

Next, as illustrated in FIG. 8, a photoresist film PR1 is formed over the semiconductor substrate SB. Here, a pattern including the photoresist film PR1 is formed by an exposure/development process. The photoresist film PR1 covers an upper surface of the insulating film IF1 in the scribe region 1B and the insulating film IF1 at the end of the element formation region 1A. That is, at the end of the element formation region 1A, the photoresist film PR1 covers the trench D1 and covers the upper surface of the insulating film IF1 exposed from the lower insulating film IF2 in a region excluding a region in the vicinity of the lower insulating film IF2. However, the photoresist film PR1 exposes the upper surface of the wiring M3 and the respective front surfaces of the interlayer insulating film IL3, the insulating film IF1, and the lower insulating film IF2 which are exposed in the opening exposing the wiring M3.

That is, the photoresist film PR1 covers a part of an upper surface of the lower insulating film IF2 and exposes a side wall of the lower insulating film IF2. The seed metal film SM directly over the lower insulating film IF2 formed from the opening of the lower insulating film IF2 exposing the wiring M3 to the side of the trench D1 is covered with the photoresist film PR1.

Thereafter, ashing may be carried out lightly to remove small residues comprised of the photoresist film remaining on the upper surface of the seed metal film SM.

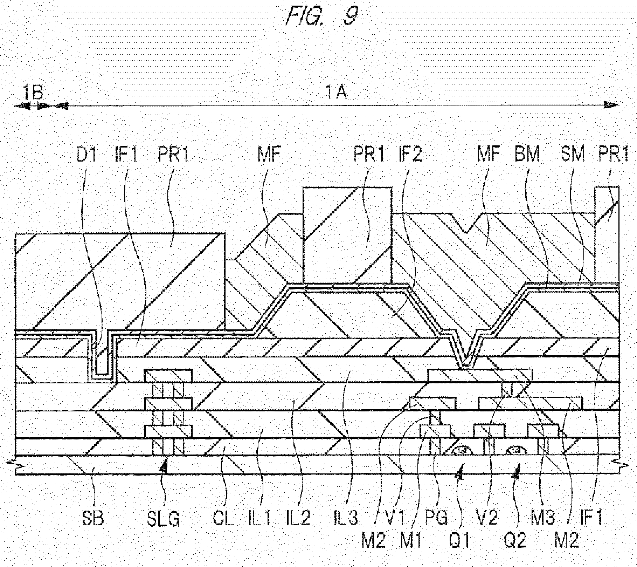

Next, as illustrated in FIG. 9, a main conductor film MF is formed, by plating, over the seed metal film SM exposed from the photoresist film PR1. The main conductor film MF is comprised of, for example, Cu (copper), Ni, Au, Ag, Pd, or a layered film thereof and has a film thickness greater than the wiring M3. The film thickness of the main conductor film MF is, for example, 5 to 12 µm. In a region where the seed metal film is covered with the photoresist film PR1, the main conductor film MF is not formed. As a result, the inside of the opening exposing the part of the upper surface of the wiring M3 is completely buried by the barrier metal film BM, the seed metal film SM, and the main conductor film MF.

Further, the side wall and the upper surface of the end of the upper insulating film IF2 on the side of the scribe region 1B is covered with the other main conductor film MF separated from the main conductor film MF buried in the opening exposing the wiring M3 from the insulating film IF1 or the like. Note that the film thickness of the main conductor film MF is smaller than a film thickness of the photoresist film PR1.

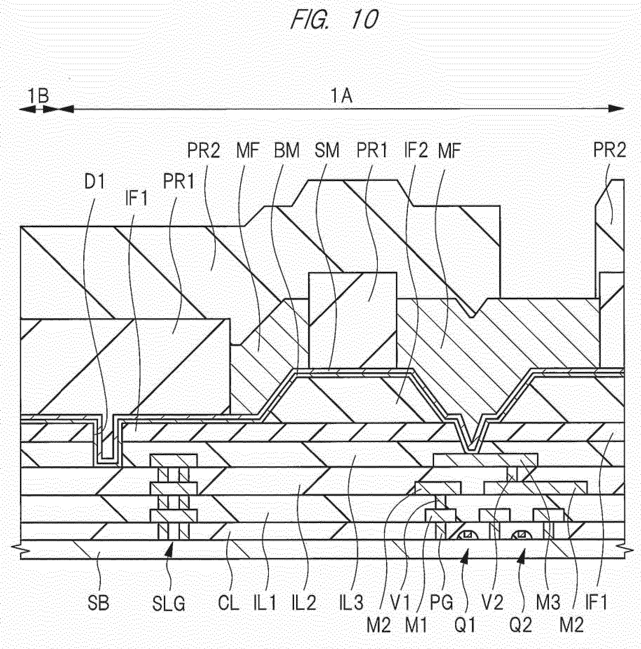

Next, as illustrated in FIG. 10, a photoresist film PR2 is formed over the semiconductor substrate SB and the photoresist film PR1. Here, a pattern including the photoresist film PR2 is formed by an exposure/development process. The photoresist film PR2 exposes an upper surface of a part of the main conductor film MF buried in the opening exposing the wiring M3 from the insulating film IF1 and the like and covers the other region. Therefore, the main conductor film MF covering the side wall and the upper surface of the end of the upper insulating film IF2 on the side of the scribe region 1B is covered with the photoresist film PR2. In addition, the photoresist film PR1 is covered with the photoresist film PR2.

Thereafter, ashing may be carried out lightly to remove small residues comprised of the photoresist film remaining on the upper surface of the main conductor film MF.

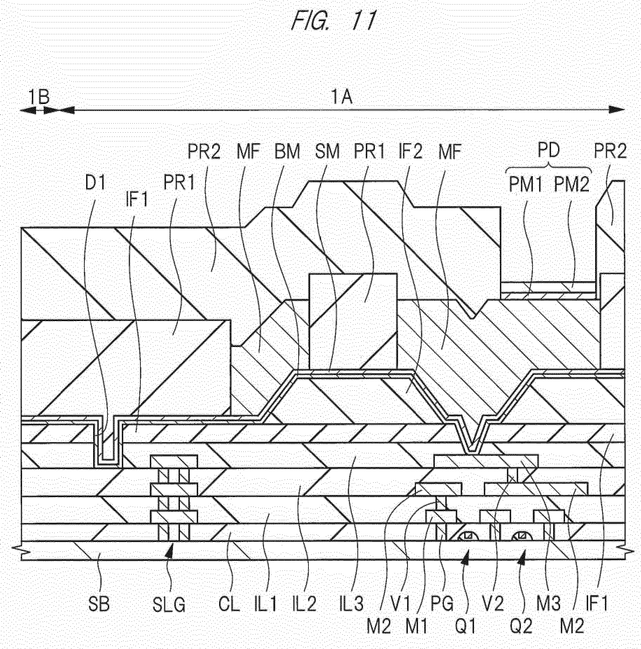

Next, as illustrated in FIG. 11, metal films PM1 and PM2 are sequentially formed as an underlying metal film over the upper surface of the main conductor film MF exposed from the photoresist film PR2 by plating. A layered film including the metal films PM1 and PM2 constitutes a second pad electrode PD. The metal film PM1 is comprised of, for example, Ni (nickel) and has a film thickness of 1.5 µm, for example. The metal film PM2 is comprised of Au (gold), for example, and has a film thickness of 2 µm, for example.

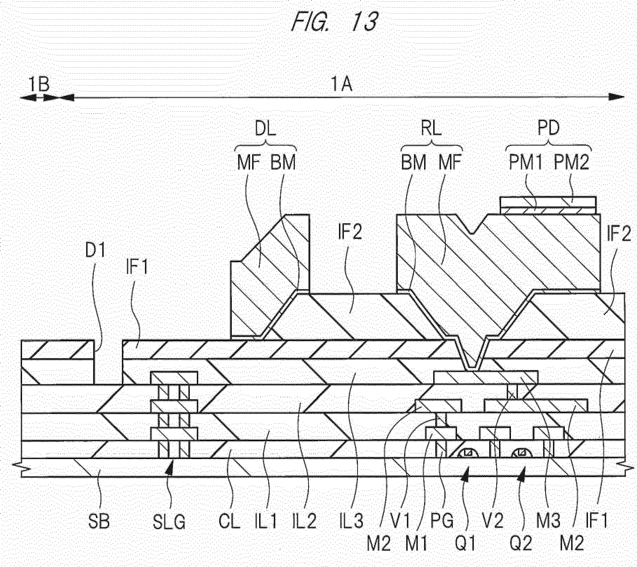

Next, as illustrated in FIG. 12 and FIG. 13, the photoresist films PR1 and PR2 are removed, and then, the seed metal film SM and the barrier metal film BM exposed from the main conductor film MF are removed. Thereafter, ashing is performed lightly to remove a part of a front surface of the lower insulating film IF2. As a result, damage occurring on the front surface of the lower insulating film IF2 in the process of removing the barrier metal film BM or the like is removed. Note that, in FIG. 13, the seed metal film SM is treated as being integrated with the main conductor film MF, and illustration of the seed metal film SM is omitted.

As illustrated in FIG. 13, each of the main conductor film MF is electrically separated by removing the seed metal film SM and the barrier metal film BM. Accordingly, a layered film including the barrier metal film BM, the seed metal film SM (not illustrated), and the main conductor film MF which are electrically connected with the upper surface of the wiring M3 constitutes a redistribution layer RL. In addition, a layered film including the barrier metal film BM, the seed metal film SM (not illustrated), and the main conductor film MF which are not electrically connected with the wiring M3 constitutes a dummy redistribution layer DL. The redistribution layer RL and the dummy redistribution layer DL are separated from each other and are not electrically connected with each other. In addition, the redistribution layer RL constitutes a circuit, and the dummy redistribution layer DL does not constitute a circuit.

As described above, the redistribution layer RL and the dummy redistribution layer DL include the barrier metal film BM and the main conductor film MF formed by the same film-forming process. That is, although the redistribution layer RL and the dummy redistribution layer DL are separated, they can be said to be films in the same layer. The term "films in the same layer" as used herein refers to films formed in the same process. Therefore, when a single film is formed and then separated into a plurality of films, the plurality of films are films in the same layer.

As illustrated in FIG. 12, over the semiconductor substrate (semiconductor wafer) SB, a plurality of the element formation regions 1A are present in a matrix, and the scribe region (scribe line) 1B is present between the adjacent element formation regions 1A. That is, the scribe region 1B is arranged in a lattice pattern. In plan view, in the element formation region 1A, the dummy redistribution layer DL has a rectangular annular structure so as to surround the plurality of redistribution layers RL and a region where the semiconductor element is formed.

As illustrated in FIG. 13, a part of the dummy redistribution layer DL is arranged directly over the lower insulating film IF2. The part of the dummy redistribution layer DL is adjacent to the redistribution layer RL directly over the lower insulating film IF2. Also, another part of the dummy redistribution layer DL covers the upper surface of the insulating film IF1 exposed from the lower insulating film IF2 at a side closer to the end of the element formation region 1A than the lower insulating film IF2.

Here, as described with reference to FIG. 8 to FIG. 13, by forming a resist pattern including the photoresist film PR1, forming the main conductor film MF, and then forming the photoresist film PR2 without removing the photoresist film PR1, the photoresist film PR2 covers the photoresist film PR1.

Compared to this, it is conceivable to remove the photoresist film PR1 after the step described with reference to FIG 9 and then form the photoresist film PR2 by coating. However, in this case, the step from the upper surface of the main conductor film MF formed with a great film thickness for the purpose of lowering the resistance to the underlying surface beside the main conductor film MF is large. If it is attempted to form a new photoresist film PR2 by coating, it is difficult to completely cover the main conductor film MF. When the main conductor film MF is exposed at a position other than the region where the second pad electrode PD is formed, the metal films PM1 and PM2 are formed over the exposed portion, resulting in a defect.

In the case of removing the photoresist film PR1 before forming the photoresist film PR2 as described above, in order to prevent occurrence of the defect due to the exposure of the main conductor film MF, it is necessary to form the photoresist film PR2 to be formed after removal of the photoresist film PR1 so as to be very thick However, in a case where the process of removing the photoresist film PR1 is performed and the photoresist film PR2 is formed so as to be very thick, the manufacturing cost of the semiconductor device increases.

In contrast, in the present embodiment, since the photoresist film PR1 buries the step at the end of the main conductor film MF, it is possible to prevent the main conductor film MF from being exposed from the resist pattern. Therefore, since occurrence of a defect can be prevented, the reliability of the semiconductor device can be improved, and yield in the manufacturing process of the semiconductor device can be improved.

In addition, since the photoresist film PR1 buries the step at the end of the main conductor film MF, the film thickness of the photoresist film PR2 can be made thin, whereby the manufacturing cost of the semiconductor device can be reduced. In addition, since the photoresist films PR1 and PR2 are removed in a single step, the process of removing the resist pattern can be reduced, thereby reducing the manufacturing cost of the semiconductor device.

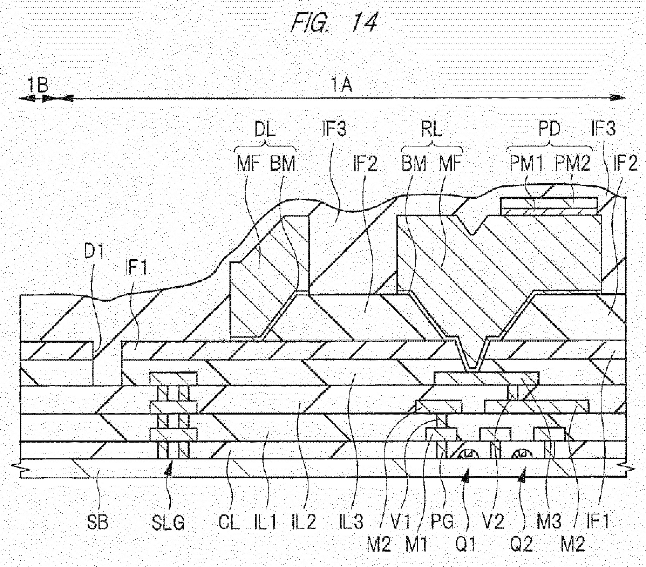

Next, as illustrated in FIG. 14, for example, liquid polyimide having photosensitivity is supplied over the main surface of the semiconductor substrate SB, that is, over the insulating film IF 1, the lower insulating film IF2, the dummy redistribution layer DL, and the redistribution layer RL by coating, thereby forming an upper insulating film IF3.

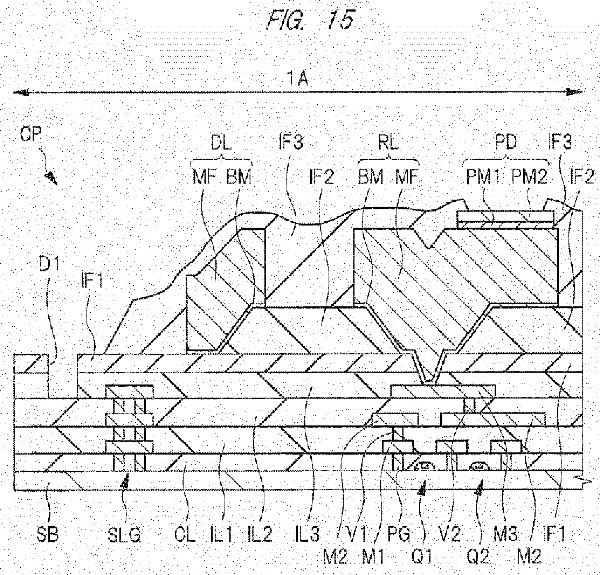

Next, as illustrated in FIG. 15, by performing the exposure/development process to remove a part of the upper insulating film IF3, an opening is formed in the insulating film IF3 (a third opening). Thereafter, the polyimide is sintered, polymerized, and fixed. Thereby, an upper surface of the second pad electrode PD, the upper surface of the insulating film IF1, a side wall of the trench D1, and the bottom surface of the trench D1 are exposed from the upper insulating film IF3. At this time, the end of the lower insulating film IF2 is kept covered with the dummy redistribution layer DL and the upper insulating film IF3. This is because, when the end of the lower insulating film IF2 is exposed at the time of processing the upper insulating film IF3 by exposure and development, the end of the lower insulating film IF2 is dissolved by developing solution, and the lower insulating film IF2 may be peeled off.

The redistribution layer RL is covered with the upper insulating film IF3 except a part of an upper surface of the redistribution layer RL covered with the second pad electrode PD. Further, the entire dummy redistribution layer DL is covered with the upper insulating film IF3. The upper surface of the lower insulating film IF2 between the redistribution layer RL and the other redistribution layer RL and the upper surface of the lower insulating film IF2 between the redistribution layer RL and the dummy redistribution layer DL are covered with the upper insulating film IF3. Furthermore, the upper surface of the insulating film IF1 in a region adjacent to the side wall of the dummy redistribution layer DL, that is, the side wall on the side closer to the end of the element formation region 1A is covered with the upper insulating film IF3. The insulating film IF1 positioned closer to the scribe region 1B than the region in the vicinity of the dummy redistribution layer DL is exposed from the upper insulating film IF3.

Next, a plurality of semiconductor chips CP are obtained by dicing the semiconductor wafer. That is, the semiconductor substrate SB is cut into individual pieces by dicing the semiconductor substrate SB in the scribe region 1B and the layered film directly over the semiconductor substrate SB. In this case, even if a cutting position is shifted due to accuracy of a dicing apparatus or the like, there is no problem as long as the region on a side closer to a center of the element formation region 1A than the trench D1 is not cut. That is, there is a possibility that the trench D1 is removed by dicing.

As described above, since the trench D1 is a portion that can be cut, the lower insulating film IF2, the redistribution layer, and the upper insulating film IF3, which are structures over the insulating film IF1, are formed only inside the trench D1 (on the side closer to the center of the element formation region 1A), and these structures are not formed directly over the trench D1.

In this way, the semiconductor chip CP (see FIG 1 and FIG 16) which is the semiconductor device of the present embodiment is manufactured. Hereinafter, effects of the method of manufacturing the semiconductor device of the present embodiment will be described.

In the case of using the method of manufacturing the semiconductor device of the present embodiment, it is possible to obtain the same effect as the effect of the semiconductor device described with reference to FIG. 1 to FIG. 3. That is, as compared with the comparative example described with reference to FIG. 23, in the present embodiment, as illustrated in FIG. 15, by providing the part of the dummy redistribution layer DL not constituting a circuit directly over the lower insulating film IF2 between the redistribution layer RL and the end of the semiconductor chip CP, the height difference of the step beside the redistribution layer RL is reduced. As a result, the film thickness of the upper insulating film IF3 formed in the vicinity of the side wall of the redistribution layer RL is increased, so that it is possible to prevent the upper end (corner portion) of the redistribution layer RL from being exposed from the upper insulating film IF3. Therefore, the reliability of the semiconductor device can be secured.

In addition, by providing the dummy redistribution layer DL, it is unnecessary to provide a wide region in which the redistribution layer RL is not formed, as in the comparative example illustrated in FIG. 24. Therefore, since a chip area can be reduced, performance of the semiconductor device can be improved. Therefore, improvement in reliability and performance of the semiconductor device can be achieved at the same time.

Further, since the end of the lower insulating film IF2 is covered with the dummy redistribution layer DL, it is possible to prevent the developing solution from dissolving the end of the lower insulating film IF2 and peeling off the lower insulating film IF2 when a part of the upper insulating film IF3 is removed by the development process.

### <First Modification Example>

Next, a cross-sectional view of the first modification example of the semiconductor device of the present embodiment is illustrated in FIG. 16. FIG. 16 is a cross-sectional view illustrating the end of the semiconductor chip, similarly to FIG. 2. As compared with the structure described with reference to FIG. 2, the semiconductor chip CP illustrated in FIG. 16 has a difference in that a part of the dummy redistribution layer DL is exposed from the upper insulating film IF3. In other word, an upper end of the side wall of the dummy redistribution layer DL, that is, the side wall on the side closer to the end of the semiconductor chip CP is exposed from the upper insulating film IF3.

Even in a case where the part of the dummy redistribution layer DL is exposed from a part of the upper insulating film IF3 in this way, the dummy redistribution layer DL does not constitute a circuit unlike the redistribution layer RL, so that no problem arises. That is, since the dummy redistribution layer DL does not constitute a circuit, even if the dummy redistribution layer DL is, for example, oxidized due to the exposure of the dummy redistribution layer DL from the upper insulating film IF3, there is no influence on operation of the semiconductor device, so that the reliability of the semiconductor device does not deteriorate.

Further, it is unnecessary to completely cover the dummy redistribution layer DL, which is the outermost wiring in the semiconductor chip CP, with the upper insulating film IF3, so that there is no need to increase the film thickness of the upper insulating film IF3. Accordingly, the viscosity of the liquid polyimide to be supplied at the time of forming the upper insulating film IF3 can be suppressed low. Therefore, the burying property upon coating the polyimide film can be improved, so that the reliability of the semiconductor device can be improved.

### <Second Modification Example>

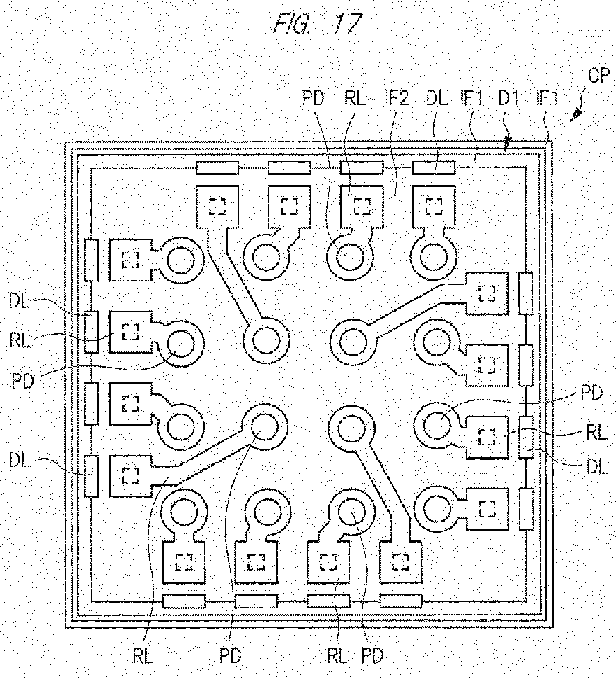

Next, a plan view of the second modification example of the semiconductor device of the present embodiment is illustrated in FIG. 17. FIG. 17 is a plan view illustrating the semiconductor chip, similarly to FIG. 1. In the semiconductor chip CP described with reference to FIG. 1, the dummy redistribution layer DL is formed in an annular shape along the peripheral portion of the semiconductor chip CP; however, in the semiconductor chip CP of the modification example illustrated in FIG. 17, the dummy redistribution layer DL is not formed in an annular shape.

That is, in the semiconductor chip CP of the modification example, a structure that the dummy redistribution layer DL is arranged directly over the lower insulating film IF2 between the end of the semiconductor chip CP and the redistribution layer RL constituting a circuit is the same as the structure described with reference to FIG. 1 and FIG. 2. However, in the modification example illustrated in FIG. 17, the dummy redistribution layer DL is formed only between the redistribution layer RL and the end of the semiconductor chip CP in the vicinity of the redistribution layer RL, and the dummy redistribution layer DL is not formed in a region where the redistribution layer RL is not arranged in the vicinity of the end of the semiconductor chip CP. That is, the dummy wiring DL of the first embodiment is continuously formed along the peripheral portion of the semiconductor chip CP; however, in the modification example of FIG. 17, the dummy wiring DL is formed discontinuously. In other words, the dummy redistribution layer DL terminates in the vicinity of the end of the side wall of the redistribution layer RL facing the side wall of the dummy redistribution layer DL, the end being in a direction along the main surface of the semiconductor substrate.

As described above, in this modification example, the dummy redistribution layer DL is arranged only at a portion necessary to prevent the redistribution layer RL from being exposed from the upper insulating film IF3 (see FIG. 2). Note that, in FIG. 2, the dummy redistribution layer DL in contact with the upper surface and the side wall of the end of the lower insulating film IF2 covers the lower insulating film IF2; however, in this modification example, in a region where the dummy redistribution layer DL is not formed, the upper insulating film IF3 is in contact with the upper surface and the side wall of the end of the lower insulating film IF2 and covers the end of the lower insulating film IF2.

In this modification example, effects similar to those of the semiconductor device described with reference to FIG. 1 and FIG. 2 can be obtained.

Here, since the redistribution layer (including the dummy redistribution layer DL) contracts small at the time of baking in order to sinter the upper insulating film IF3, there is a problem that causes warpage of the semiconductor wafer. Such a problem becomes conspicuous because the redistribution layer is thicker than the wiring in the layered wiring layer. In contrast, in the present modification example, by limiting the formation position of the dummy redistribution layer DL between the redistribution layer RL and the end of the semiconductor chip CP in the vicinity of the redistribution layer RL, it is possible to reduce an occupying ratio of the dummy redistribution layer DL in the entire semiconductor chip CP in plan view as compared with the layout illustrated in FIG. 1. As a result, it is possible to prevent the semiconductor wafer from being warped due to the formation of the redistribution layer in a wide range. Therefore, the reliability of the semiconductor device can be improved, and the yield in the manufacture of the semiconductor device can be improved.

Furthermore, by preventing the semiconductor wafer from warping, when the semiconductor wafer is fixed and transported by using a vacuum chuck or the like, it is possible to prevent occurrence of abnormality upon transportation caused by difficulty in fixing of the semiconductor wafer due to warpage of the semiconductor wafer.

### (Second Embodiment)

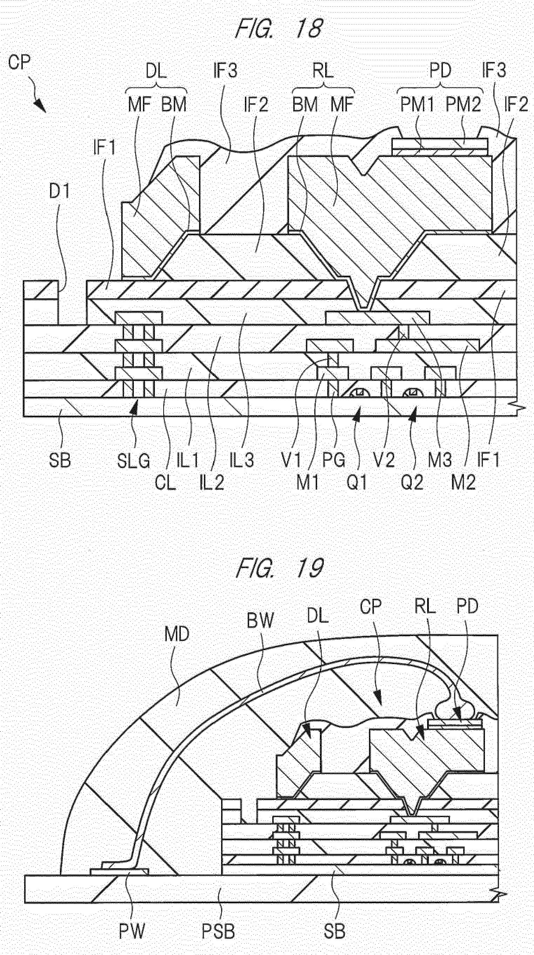

Next, a semiconductor device according to a second embodiment will be described with reference to FIG. 18 and FIG. 19. FIG. 18 is a cross-sectional view illustrating an end of a semiconductor chip which is the semiconductor device of the present embodiment Also, FIG. 19 is a cross-sectional view illustrating a structure in which the semiconductor chip which is the semiconductor device of the present embodiment is mounted over a substrate.

As illustrated in FIG. 18, the structure of the semiconductor device of the present embodiment is the same as the structure described with reference to FIG. 2 in the first embodiment except for a shape of an upper insulating film IF3 and a distance from a dummy redistribution layer DL to an end of the semiconductor chip CP. That is, as illustrated in FIG. 18, the upper insulating film IF3 of the present embodiment exposes a side wall of the dummy redistribution layer DL, which is a side wall on a side closer to the end of the semiconductor chip CP. Also, the distance from the dummy redistribution layer DL to the end of the semiconductor chip CP is reduced as much as the upper insulating film IF3 covering the side wall of a part of the dummy redistribution layer DL is not formed.

As described in the first modification example of the first embodiment (see FIG. 16), there is no problem even if a part of the dummy redistribution layer DL is exposed from the upper insulating film IF3. Therefore, in the present embodiment, the side wall of the dummy redistribution layer DL is exposed from the upper insulating film IF3 directly over an insulating film IF1 exposed from a lower insulating film IF2.

In contrast, a side wall of the dummy redistribution layer DL positioned directly over the lower insulating film IF2 is completely covered with the upper insulating film IF3. This is because a redistribution layer RL can be prevented from being exposed from the upper insulating film IF3 by keeping a great film thickness of the upper insulating film IF3 between the dummy redistribution layer DL and the redistribution layer RL which are adjacent to each other, and because the lower insulating film IF2 not covered with the dummy redistribution layer DL is covered with the upper insulating film IF3.

As illustrated in FIG. 17, when the structure of the present embodiment is applied in a case where the dummy redistribution layer DL is arranged only in a partial region in the vicinity of the end of the semiconductor chip CP, in a region where the dummy redistribution layer DL is not formed, the upper insulating film IF3 in contact with the lower insulating film IF2 covers a side wall and an upper surface of an end of the lower insulating film IF2. Note that, here, a part of an upper surface of the dummy redistribution layer DL is also exposed from the upper insulating film IF3.

In the present embodiment, since the upper insulating film IF3 is not formed between the trench D1 and the dummy redistribution layer DL, it is possible to reduce a distance between the dummy redistribution layer DL and a trench D1 or the end of the semiconductor chip CP. In other words, it is possible to obtain the same effect as in the first embodiment, and in addition, a chip area can be reduced.

In this case, a seal ring SLG and the dummy redistribution layer DL can be arranged so as to overlap with each other in plan view. In other words, it is possible to arrange the side wall of the dummy redistribution layer DL on a side of the trench D1 and an end of the seal ring SLG on the side of the trench D1 at a position overlapping with each other in plan view. Therefore, in a direction along a main surface of a semiconductor substrate SB, a width of a region (seal ring region) from the redistribution layer RL closest to the end of the semiconductor chip CP to the end of the seal ring SLG on the side of the trench D1 is, for example, 10 to 27 µm. That is, for example, a width from the dummy redistribution layer DL in the same direction to the end of the seal ring SLG on the side of the trench D1 is approximately 0 µm, a width of the dummy redistribution layer DL in the same direction is 5 to 12 µm, and a distance between the dummy redistribution layer DL and the redistribution layer RL in the same direction is 5 to 15 µm.

As illustrated in FIG. 19, in a case where the semiconductor chip CP of the present embodiment is mounted on a substrate PSB and the semiconductor chip CP is covered with a sealing body MD after bonding, a mold resin which is an insulator constituting the sealing body MD and a part of the dummy redistribution layer DL are brought into contact with each other. Therefore, the dummy redistribution layer DL is easily oxidized by halogen or moisture in the sealing body MD, but since the dummy redistribution layer DL does not constitute a circuit, the reliability of the semiconductor device does not decrease.

### (Third Embodiment)

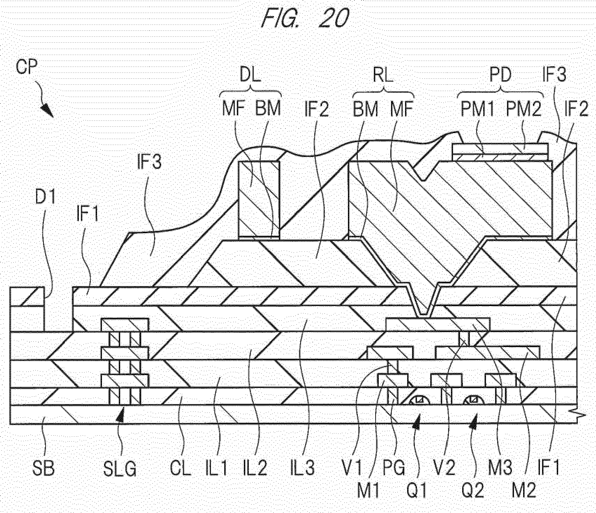

Next, a semiconductor device according to a third embodiment will be described with reference to FIG. 20. FIG. 20 is a cross-sectional view illustrating an end of a semiconductor chip which is a semiconductor device of the present embodiment.

As illustrated in FIG. 20, a structure of the semiconductor device of this embodiment is the same as the structure described with reference to FIG. 2 in the first embodiment except that a dummy redistribution layer DL is formed directly over the lower insulating film IF2. That is, parts of side walls of the dummy redistribution layer DL are all present directly over the lower insulating film IF2, and the dummy redistribution layer DL is not formed directly over an insulating film IF 1 exposed from the lower insulating film IF2. In other words, the dummy redistribution layer DL is separated from a terminal portion of the lower insulating film IF2.

That is, the entire dummy redistribution layer DL is formed between the redistribution layer RL and the end of the lower insulating film IF2. With this structure, it is possible to obtain the same effect as in the first embodiment However, unlike the first embodiment, since the end of the lower insulating film IF2 is not covered with the dummy redistribution layer DL, it is impossible to prevent developing solution from dissolving the end of the lower insulating film IF2 in a case where the lower insulating film IF2 is exposed when a part of the upper insulating film IF3 is removed by a development process. Therefore, in the present embodiment, it is necessary to develop the upper insulating film IF3 so as not to expose the end of the lower insulating film IF2.

Here, since the dummy redistribution layer DL is arranged in the vicinity of the end of the lower insulating film IF2, a large step is formed in the vicinity of the side wall of the dummy redistribution layer DL, that is, the side wall on the side closer to the end of the semiconductor chip CP. Therefore, similarly to the comparative example described with reference to FIG. 23 and FIG. 24, a part of the dummy redistribution layer DL of the present embodiment may be exposed from the upper insulating film IF3 due to manufacturing variations. However, since the dummy redistribution layer DL does not constitute a circuit, even if oxidation proceeds by coming into contact with the sealing body MD (see FIG. 3), the reliability of the semiconductor device does not deteriorate.

### (Fourth Embodiment)

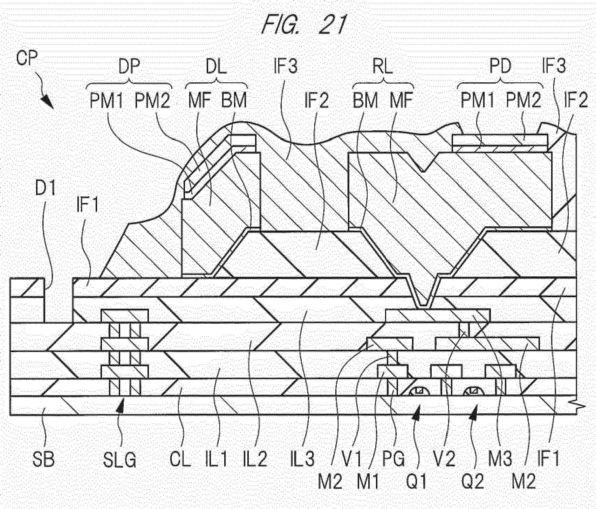

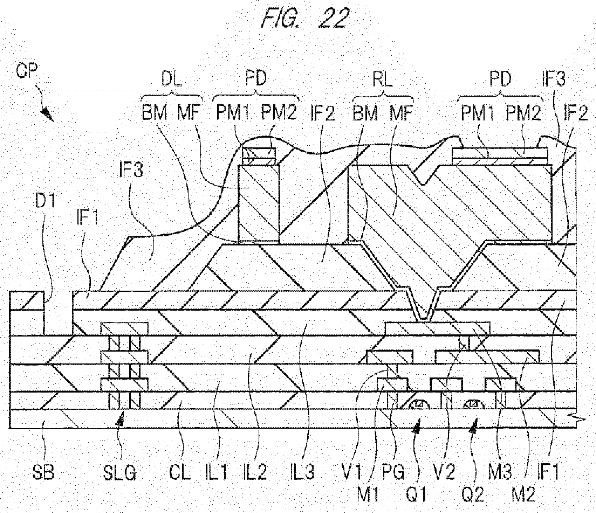

Next, a semiconductor device according to a fourth embodiment will be described with reference to FIG. 21 and FIG. 22. FIG. 21 and FIG. 22 are cross-sectional views each illustrating an end of a semiconductor chip which is a semiconductor device of the present embodiment. In the semiconductor device of this embodiment, as compared with the structure described in the first embodiment, a height of a wiring including a dummy redistribution layer (redistribution layer for film thickness adjustment) is made greater. That is, as illustrated in FIG. 21 and FIG. 22, here, by forming a layered film including a metal film PM1 in contact with an upper surface of the dummy redistribution layer DL and a metal film PM2 formed over the metal film PM1, the height of the redistribution layer for film thickness adjustment is increased.

The layered film including the metal films PM1 and PM2 formed directly over the dummy redistribution layer DL constitutes a dummy pad electrode DP. The dummy pad electrode DP is a metal film which does not constitute a circuit The metal film PM1 is comprised of, for example, Ni (nickel), and the metal film PM2 is comprised of a noble metal that is resistant to oxidation, and is comprised of, for example, Au (gold) or palladium (Pd), or an alloy thereof.

In the process described with reference to FIG. 10, an upper surface of a main conductor film MF to be the dummy redistribution layer DL in a later process is exposed from a photoresist film PR2, and then, in the process described with reference to FIG. 11, the dummy pad electrode DP can be formed at the same time as a second pad electrode PD. In other words, the metal film PM1 constituting the second pad electrode PD and the metal film PM1 constituting the dummy pad electrode DP are films in the same layer. The metal film PM2 constituting the second pad electrode PD and the metal film PM2 constituting the dummy pad electrode DP are films in the same layer.

In the present embodiment, by forming the dummy pad electrode DP over the dummy redistribution layer DL, it is possible to increase the height of the film including the dummy redistribution layer DL, that is, the film provided for adjusting a film thickness of an upper insulating film IF3. This makes it possible to reduce an amount of polyimide flowing into a step on a side of a scribe region when the polyimide is applied in the process of forming the upper insulating film IF3, so that coverage of the redistribution layer RL constituting a circuit can be improved.

Similarly to the structure illustrated in FIG. 2, FIG. 21 illustrates a cross section of the semiconductor chip CP in a case where the dummy redistribution layer DL is formed from a region directly over an insulating film IF1 exposed from a lower insulating film IF2 to a region directly over the lower insulating film IF2. Similarly to the structure illustrated in FIG. 20, FIG. 22 illustrates a cross section of the semiconductor chip CP in a case where the entire dummy redistribution layer DL is formed directly over the lower insulating film IF2.

In the structure illustrated in FIG. 22, as compared with the structure illustrated in FIG. 20, since a height of a film thickness adjustment film including the dummy redistribution layer DL is increased, the coverage of the film thickness adjustment film serving as the upper insulating film IF3 is deteriorated, and a possibility that an upper part of the film thickness adjustment film on a side closer to an end of the semiconductor chip CP is exposed from the upper insulating film IF3 is increased. However, since an uppermost part of the film thickness adjustment film includes the metal film PM2 resistant to oxidation, oxidation hardly occurs even when the upper part of the film thickness adjustment film is exposed from the upper insulating film IF3. Furthermore, even if oxidation occurs, the dummy redistribution layer DL does not constitute a circuit, so that the reliability of the semiconductor device does not deteriorate.

In the foregoing, the invention made by the inventors of the present invention has been concretely described based on the embodiments. However, it is needless to say that the present invention is not limited to the foregoing embodiments and various modifications and alterations can be made within the scope of the present invention.

### EXPLANATION OF REFERENCE CHARACTERS

- 1A: Element formation region
- 1B: Scribe region
- BM: Barrier metal film
- CL: Interlayer insulating film
- CP: Semiconductor chip
- D1: Trench
- DL: Dummy redistribution layer (dummy pattern)
- IF1: Insulating film
- IF2: Lower insulating film
- IF3: Upper insulating film
- IL1 to IL3: Interlayer insulating film
- M1, M2: Wiring
- M3: Wiring (first pad electrode)
- MF: Main conductor film
- PD: Underlying metal film (second pad electrode)
- PG: Contact plug
- PM1, PM2: Metal film
- PSB: Substrate
- PR1, PR2: Photoresist film
- PW: Wiring
- Q1, Q2: MISFET
- RL: Redistribution layer
- SB: Semiconductor substrate
- SLG: Seal ring
- V1, V2: Via

## Claims

1. A method of manufacturing a semiconductor device, comprising the steps of:
(a) preparing a semiconductor substrate having an element formation region and a scribe region surrounding the element formation region, and having, in the element formation region, a plurality of wiring layers and a pad electrode formed in an uppermost layer of the plurality of wiring layers;
(b) forming a first insulating film having a first opening over the pad electrode;
(c) forming a second insulating film having a second opening over the first insulating film;
(d) forming a redistribution layer electrically connected with the pad electrode via the first and the second openings over the second insulating film;
(e) forming a dummy pattern over the second insulating film and in a region closer to the scribe region than the redistribution layer; and
(f) forming a third insulating film over the redistribution layer and over the dummy pattern, the third insulating film having a third opening above the redistribution layer.

2. The method of manufacturing a semiconductor device according to claim 1,
wherein the third insulating film covers a part of the dummy pattern.

3. The method of manufacturing a semiconductor device according to claim 2,
wherein the third insulating film covers the entire dummy pattern.

4. The method of manufacturing a semiconductor device according to claim 1,
wherein a seal ring formed of conductor films in same layers as the plurality of wiring layers is formed between the element formation region and the scribe region, and
wherein the dummy pattern is formed between the seal ring and the redistribution layer or above the seal ring.

5. The method of manufacturing a semiconductor device according to claim 4,
wherein a trench is formed in the first insulating film on a side closer to the scribe region than the seal ring.

6. The method of manufacturing a semiconductor device according to claim 1,
wherein the dummy pattern is formed in a same layer as the redistribution layer.

7. The method of manufacturing a semiconductor device according to claim 1,
wherein the formation of the dummy pattern in the step (e) is performed in a same step as the formation of the redistribution layer in the step (d).

8. The method of manufacturing a semiconductor device according to claim 1, further comprising the step of:
(g) after the step (d), forming an underlying metal film over the redistribution layer in the third opening,
wherein the formation of the dummy pattern in the step (e) is performed in a same step as the formation of the redistribution layer in the step (d) and the formation of the underlying metal film in the step (f).

9. The method of manufacturing a semiconductor device according to claim 1,
wherein, in the step (f), the third insulating film comprised of an organic film is formed by coating.

10. The method of manufacturing a semiconductor device according to claim 1,
wherein the pad electrode is comprised of a material containing aluminum as a main component, and
wherein the redistribution layer is comprised of a material containing copper as a main component and is formed with a film thickness greater than the pad electrode.

11. The method of manufacturing a semiconductor device according to claim 1,
wherein the dummy pattern is electrically separated from the redistribution layer.

12. The manufacturing method of a semiconductor device according to claim 11,
wherein a MISFET is formed in the semiconductor substrate in the element formation region,
wherein the pad electrode is electrically connected with the MISFET, and
wherein the dummy pattern is not electrically connected with the MISFET.

13. A semiconductor device comprising:
a semiconductor substrate having an element formation region and a scribe region surrounding the element formation region;
a plurality of wiring layers formed in the element formation region;
a pad electrode formed in an uppermost layer of the plurality of wiring layers;
a first insulating film formed over the pad electrode and having a first opening;
a second insulating film formed over the first insulating film and having a second opening;
a redistribution layer formed over the second insulating film and electrically connected with the pad electrode via the first and the second openings;
a dummy pattern arranged over the second insulating film and in a region closer to the scribe region than the redistribution layer; and
a third insulating film having a third opening above the redistribution layer and formed over the redistribution layer and over the dummy pattern.

14. The semiconductor device according to claim 13,
wherein the third insulating film covers a part of the dummy pattern.

15. The semiconductor device according to claim 14,
wherein the third insulating film covers the entire dummy pattern.

16. The semiconductor device according to claim 13,
wherein a seal ring formed of conductor films in same layers as the plurality of wiring layers is formed between the element formation region and the scribe region, and
wherein the dummy pattern is formed between the seal ring and the redistribution layer or above the seal ring.

17. The semiconductor device according to claim 16,
wherein a trench is formed in the first insulating film on a side closer to the scribe region than the seal ring.

18. The semiconductor device according to claim 13,
wherein the dummy pattern includes a film in a same layer as the redistribution layer.

19. The semiconductor device according to claim 13, comprising:
an underlying metal film formed over the redistribution layer in the third opening,
wherein the dummy pattern includes a film in a same layer as the redistribution layer and the underlying metal film.

20. The semiconductor device according to claim 19,
wherein the underlying metal film is formed of a layered film comprised of Ni andAu.

21. The semiconductor device according to claim 13, further comprising:
an underlying metal film formed over the redistribution layer in the third opening;
an external connection terminal formed on the underlying metal film; and
a mold resin covering the external connection terminal, the third insulating film, and the dummy pattern,
wherein the redistribution layer is not in contact with the mold resin.

22. The semiconductor device according to claim 13,
wherein the third insulating film is an organic film formed by coating.

23. The semiconductor device according to claim 13,
wherein the pad electrode is comprised of a material containing aluminum as a main component, and
wherein the redistribution layer is comprised of a material containing copper as a main component and is formed with a film thickness greater than the pad electrode.

24. The semiconductor device according to claim 13,
wherein the dummy pattern is electrically separated from the redistribution layer.

25. The semiconductor device according to claim 24,
wherein a MISFET is formed in the semiconductor substrate in the element formation region,
wherein the pad electrode is electrically connected with the MISFET, and
wherein the dummy pattern is not electrically connected with the MISFET.

26. The semiconductor device according to claim 13,
wherein the dummy pattern is arranged along an entire periphery along the scribe region.

27. The semiconductor device according to claim 13,
wherein the dummy pattern is in an annular shape formed along an outer peripheral portion of the semiconductor substrate in plan view.

28. The semiconductor device according to claim 13,
wherein the dummy pattern terminates in a vicinity of an end of a side wall of the redistribution layer lacing the dummy pattern, the end being in a direction along a main surface of the semiconductor substrate.
